# EUROPEAN PATENT APPLICATION

(11) **EP 4 852 061 A1**
(43) Date of publication of application: **09.12.2026**
(21) Application number: 24922550.9
(22) Date of filing: 07.11.2024
(51) Int. Cl.: H01L 25/075, H10H 20/857, H10H 20/831, H10H 20/84, H10D 86/00

(54) **DISPLAY DEVICE AND MANUFACTURING METHOD THEREFOR**

(30) Priority: 31.01.2024 KR 20240015237
(71) Applicant: Samsung Display Co., Ltd., Yongin-si, Gyeonggi-do 17113 (KR)
(72) Inventor: PARK, Do Yeong, Yongin-si, Gyeonggi-do 17113 (KR); KIM, Kwi Hyun, Yongin-si, Gyeonggi-do 17113 (KR); PYO, Ki Hyun, Yongin-si, Gyeonggi-do 17113 (KR); HONG, Sung Chul, Yongin-si, Gyeonggi-do 17113 (KR)
(74) Representative: Marks & Clerk LLP
(86) International application number: PCT/KR2024/017511
(87) International publication number: WO 2025/164887

(57) **Abstract**

A display device includes: a substrate; a pixel circuit layer disposed on the substrate; and a display element layer disposed on the pixel circuit layer. The display element layer may include: a first bank including a first opening; a first light emitting element disposed in the first opening, and including a first bonding electrode and a second bonding electrode, the first bonding electrode being electrically connected to an electrode of a first transistor disposed in the pixel circuit layer; a second bank disposed on the first bank, and including a second opening at least partially overlapping the first opening in a vertical direction; and a second light emitting element disposed in the second opening, and including a third bonding electrode and a fourth bonding electrode, the third bonding electrode being electrically connected to the second bonding electrode.

## Description

### Technical Field

Various embodiments relate to a display device and a method of fabricating the display device.

### Background Art

With the development of information technology, the importance of a display device, which is a connection medium between a user and information, has been emphasized. Owing to the importance of display devices, the use of various kinds of display devices, such as a liquid crystal display device and an organic light-emitting display device, has increased.

According to the use environment of the display devices, users may experience difficulty in viewing images. For example, in the case where the display devices are used outdoors, the users may have difficulty in viewing images due to the relatively high intensity of external light.

### Detailed Description of Invention

### Technical Problem

Various embodiments are directed to a display device capable of emitting light with a relatively high luminance based on the same current, and a method of fabricating the display device.

### Technical Solution

An embodiment provides a display device, including: a substrate; a pixel circuit layer disposed on the substrate; and a display element layer disposed on the pixel circuit layer. The display element layer includes: a first bank including a first opening; a first light emitting element disposed in the first opening, and including a first bonding electrode and a second bonding electrode, the first bonding electrode being electrically connected to an electrode of a first transistor disposed in the pixel circuit layer; a second bank disposed on the first bank, and including a second opening at least partially overlapping the first opening in a vertical direction; and a second light emitting element disposed in the second opening, and including a third bonding electrode and a fourth bonding electrode, the third bonding electrode being electrically connected to the second bonding electrode.

The display element layer may further include: a first anode electrode disposed under the first bank, and electrically connected to the electrode of the first transistor; and a first reflective electrode disposed on the first anode electrode and the first bank, and connecting the first bonding electrode and the first anode electrode.

The display element layer may further include: a first cathode electrode disposed under the first bank; and a second reflective electrode disposed on the first cathode electrode and the first bank, and connecting the second bonding electrode and the first cathode electrode.

The display element layer may further include a second anode electrode connecting the second reflective electrode and the third bonding electrode.

The display element layer may further include: a common electrode connected in common to a plurality of sub-pixel circuits; and a second cathode electrode electrically connecting the fourth bonding electrode and the common electrode.

The display element layer may further include a common connection electrode disposed on the first bank and the common electrode, and connected to the second cathode electrode.

The common connection electrode may be spaced apart from the first reflective electrode.

The common connection electrode may be connected in common to the plurality of sub-pixel circuits.

The second cathode electrode may be connected in common to the plurality of sub-pixel circuits.

The first light emitting element may include an n-type semiconductor layer and a p-type semiconductor layer. The first bonding electrode may be connected to the p-type semiconductor layer of the first light emitting element. The second bonding electrode may be connected to the n-type semiconductor layer of the first light emitting element.

The second light emitting element may include an n-type semiconductor layer and a p-type semiconductor layer. The third bonding electrode may be connected to the p-type semiconductor layer of the second light emitting element. The fourth bonding electrode may be connected to the n-type semiconductor layer of the second light emitting element.

An embodiment provides a method of fabricating a display device, including: preparing a substrate; forming a pixel circuit layer on the substrate; and forming a display element layer on the pixel circuit layer. The forming of the display element layer includes: forming a first bank including a first opening; disposing a first light emitting element in the first opening; forming, on the first bank, a second bank including a second opening at least partially overlapping the first opening in a vertical direction; and disposing a second light emitting element in the second opening. The first light emitting element and the second light emitting element are connected in series to each other.

The forming of the display element layer may further include: forming a first contact hole in a first insulating layer of the pixel circuit layer; and forming a first anode electrode, a first cathode electrode, and a common electrode on the first insulating layer. The first anode electrode may overlap the first contact hole.

The forming of the display element layer may further include: forming a first reflective electrode disposed on the first bank and the first anode electrode, a second reflective electrode disposed on the first bank and the first cathode electrode, and a common connection electrode disposed on the first bank and the common electrode.

The disposing of the first light emitting element may further include disposing a first bonding electrode of the first light emitting element on the first reflective electrode, and disposing a second bonding electrode of the first light emitting element on the second reflective electrode.

The forming of the display element layer may further include: forming a second insulating layer on the first light emitting element; and forming, in the second insulating layer, a second contact hole through which the second reflective electrode is exposed, and a third contact hole through which the common connection electrode is exposed.

The forming of the display element layer may further include forming a second anode electrode and a second cathode electrode on the second insulating layer. The second anode electrode may overlap the second contact hole. The second cathode electrode may overlap the third contact hole.

The disposing of the second light emitting element comprises disposing a third bonding electrode of the second light emitting element on the second anode electrode, and disposing a fourth bonding electrode of the second light emitting element on the second cathode electrode.

The second cathode electrode may be connected in common to a plurality of sub-pixel circuits.

The common electrode may be connected in common to the plurality of sub-pixel circuits.

### Advantageous Effects

Various embodiments may provide a display device capable of emitting light with a relatively high luminance based on the same current, and a method of driving the display device.

### Brief Description of Drawings

FIG. 1 is a block diagram illustrating an embodiment of a display device.
FIG. 2 is a block diagram illustrating an embodiment of any one of sub-pixels of FIG. 1.
FIG. 3 is a plan view illustrating an embodiment of a display panel of FIG. 1.
FIG. 4 is a cross-sectional view illustrating an embodiment of the display panel of FIG. 3.
FIG. 5 is a cross-sectional view illustrating another embodiment of the display panel of FIG. 3.
FIG. 6 is a cross-sectional view illustrating an embodiment of a sub-pixel.
FIGS. 7 to 13 are diagrams for describing a method of fabricating a pixel including the sub-pixel of FIG. 6.
FIG. 14 is a cross-sectional view taken along line II-II' of FIGS. 7 to 13.
FIGS. 15 to 21 are diagrams illustrating other embodiments of an arrangement structure of light emitting elements.
FIG. 22 is a block diagram illustrating an embodiment of a display system.
FIGS. 23 to 26 are perspective views illustrating application examples of a display system of FIG. 22.

### Mode for Invention

Hereinafter, an embodiment of the present invention will be described in detail with reference to the attached drawings. In the following description, only parts required for understanding of operations in accordance with the present disclosure will be described, and explanation of the other parts will be omitted not to make the gist of the present disclosure unclear. Accordingly, the present disclosure is not limited to the embodiments set forth herein but may be embodied in other types. Rather, these embodiments are provided so that the present disclosure will be thorough and complete, and will fully convey the technical spirit of the disclosure to those skilled in the art.

It will be understood that when an element is referred to as being "coupled" or "connected" to another element, it can be directly coupled or connected to the other element or intervening elements may be present therebetween. The terminology used herein is for the purpose of describing particular embodiments only and is not intended to be limiting. In the specification, when an element is referred to as "comprising" or "including" a component, it does not preclude another component but may further include other components unless the context clearly indicates otherwise. "at least one of X, Y, and Z" and "at least one selected from the group consisting of X, Y, and Z" may be construed as X only, Y only, Z only, or any combination of two or more of X, Y, and Z (for instance, XYZ, XYY, YZ, and ZZ). As used herein, the term "and/or" can include any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "below," "above," and the like, may be used herein for descriptive purposes, and, thereby, to describe one element or feature's relationship to another element(s) or feature(s), as illustrated in the drawings. Spatially relative terms are intended to encompass different orientations of an apparatus in use, operation, and/or manufacture in addition to the orientation depicted in the drawings. For example, if the device in the drawings is turned upside down, elements described as "below" or "beneath" other elements or features would then be oriented "above" the other elements or features. Thus, the term "below" can encompass both an orientation of above and below. Furthermore, the device may be otherwise oriented (e.g., rotated 90 degrees or at other orientations), and, as such, the spatially relative descriptors used herein interpreted accordingly.

Various embodiments will be described with reference to diagrams illustrating idealized embodiments. As such, variations from the shapes of the illustrations as a result, for example, of manufacturing techniques and/or tolerances, are to be expected. Therefore, embodiments disclosed herein should not be construed as limited to the particular illustrated shapes of regions, but are to include deviations in shapes that result from, for instance, manufacturing. As such, the shapes illustrated in the drawings may not illustrate the actual shapes of regions of a device, and, as such, are not intended to be limiting.

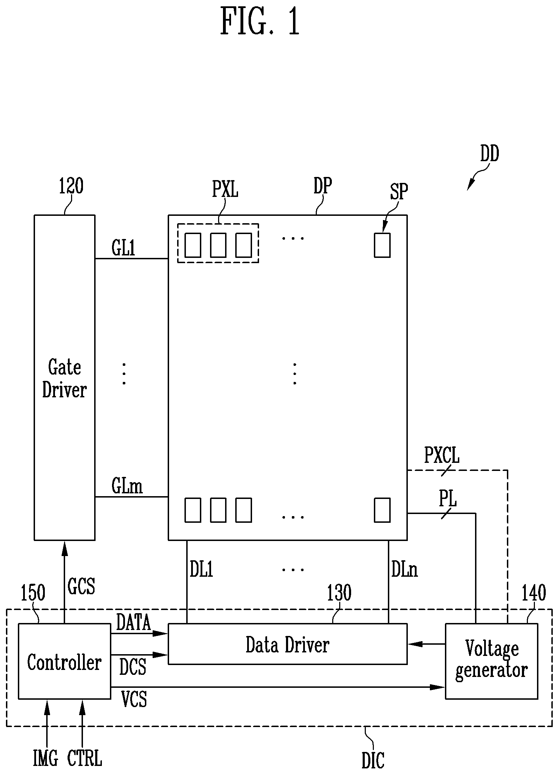

FIG. 1 is a block diagram illustrating an embodiment of a display device.

Referring to FIG. 1, the display device DD may include a display panel DP, a gate driver 120, a data driver 130, a voltage generator 140, and a controller 150.

The display panel DP may include sub-pixels SP. The sub-pixels SP may be connected to the gate driver 120 through first to m-th gate lines GL1 to GLm. The sub-pixels SP may be connected to the data driver 130 through first to n-th data lines DL1 to DLn.

The sub-pixels SP may generate light in two or more colors. For example, each of the sub-pixels SP may generate light in a color such as red, green, blue, cyan, magenta, or yellow.

Two or more sub-pixels among the sub-pixels SP may form a pixel (or single pixel) PXL. For example, the pixel PXL may include three sub-pixels, as illustrated in FIG. 1. For example, the pixel PXL may emit light of various colors and various luminances according to the combination of light emitted from the sub-pixels included therein.

The gate driver 120 may be connected to sub-pixels SP arranged in a row direction through first to m-th gate lines GL1 to GLm. The gate driver 120 may output gate signals to the first to m-th gate lines GL1 to GLm in response to a gate control signal GCS. In embodiments, the gate control signal GCS may include a start signal, which instructs each frame to start, a horizontal synchronization signal, and the like.

The gate driver 120 may be disposed on a side of the display panel DP. However, embodiments are not limited thereto. For example, the gate driver 120 may be divided into two or more drivers that are physically and/or logically distinguished from each other. The two or more drivers may be disposed on a first side of the display panel DP and a second side of the display panel DP opposite to the first side. For example, the gate driver 120 may be disposed around the display panel DP in various forms according to embodiments.

The data driver 130 may be connected to sub-pixels SP arranged in a column direction through the first to n-th data lines DL1 to DLn. The data driver 130 may receive image data DATA and a data control signal DCS from the controller 150. The data driver 130 may operate in response to the data control signal DCS. In embodiments, the data control signal DCS may include a source start signal, a source shift clock signal, a source output enable signal, and the like.

The data driver 130 may receive voltages from the voltage generator 140. The data driver 130 may apply, using received voltages, data signals having grayscale voltages corresponding to the image data DATA to the first to n-th data lines DL1 to DLn. When a gate signal is applied to each of the first to m-th gate lines GL1 to GLm, data signals corresponding to the image data DATA may be applied to the data lines DL1 to DLn. Hence, the sub-pixels SP may generate light corresponding to the data signals, and the display panel DP may display an image.

In embodiments, the gate driver 120 and the data driver 130 may include complementary metal-oxide semiconductor (CMOS) circuit elements.

The voltage generator 140 may operate in response to a voltage control signal VCS provided from the controller 150. The voltage generator 140 may generate a plurality of voltages and provide the generated voltages to components of the display device DD such as the gate driver 120, the data driver 130, and the controller 150. The voltage generator 140 may receive an input voltage from an external device of the display device DD and generate a plurality of voltages by regulating the received voltage.

The voltage generator 140 may generate a first power voltage and a second power voltage. The generated first and second power voltages may be provided to the sub-pixels SP through power lines PL. In other embodiments, at least one of the first and second power voltages may be provided from an external device to the display device DD.

For example, the voltage generator 140 may provide various voltages and/or signals. For example, the voltage generator 140 may provide one or more initialization voltages to be applied to the sub-pixels SP. For example, during a sensing operation for sensing electrical characteristics of transistors and/or light emitting elements of the sub-pixels SP, a certain reference voltage may be applied to each of the first to n-th data lines DL1 to DLn. The voltage generator 140 may generate the reference voltage and transmit the reference voltage to the data driver 130. For example, during a display operation for displaying an image on the display panel DP, common pixel control signals may be applied to the sub-pixels SP, and the voltage generator 140 may generate the pixel control signals. In embodiments, the voltage generator 140 may provide pixel control signals to the sub-pixels SP through pixel control lines PXCL. Although FIG. 1 illustrates the case where the pixel control lines PXCL are connected between the voltage generator 140 and the display panel DP, embodiments are not limited thereto. For example, the pixel control lines PXCL may be connected between the gate driver 120 and the display panel DP. For example, the pixel control signals may be transmitted from the voltage generator 140 to the sub-pixels SP through the gate driver 120 and the pixel control lines PXCL.

The controller 150 may control overall operations of the display device DD. The controller 150 may receive input image data IMG and a control signal CTRL corresponding to the input image data IMG from an external device. The controller 150 may provide a gate control signal GCS, a data control signal DCS, and a voltage control signal VCS, in response to the control signal CTRL.

The controller 150 may convert the input image data IMG to be compatible with (or suitable for) the display device DD or the display panel DP and then output image data DATA. In embodiments, the controller 150 may align the input image data IMG to be compatible with (or suitable for) the sub-pixels SP on a row basis and then output the image data DATA.

Two or more components of the data driver 130, the voltage generator 140, and the controller 150 may be mounted on a single integrated circuit. As illustrated in FIG. 1, the data driver 130, the voltage generator 140, and the controller 150 may be included (or embedded) in a driver integrated circuit DIC. For example, the data driver 130, the voltage generator 140, and the controller 150 may be components that are functionally separated from each other in the single driver integrated circuit DIC. In other embodiments, at least one of the data driver 130, the voltage generator 140, and the controller 150 may be provided (or formed) as a component separated from the driver integrated circuit DIC.

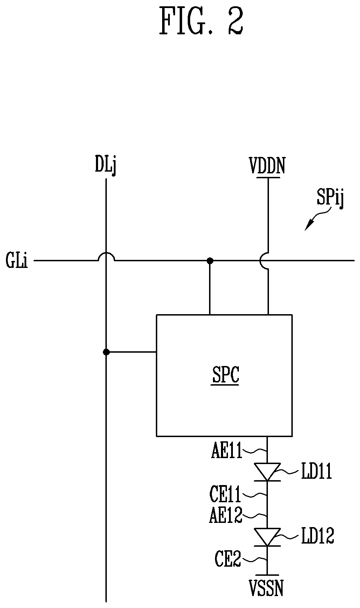

FIG. 2 is a block diagram illustrating an embodiment of any one of sub-pixels of FIG. 1. In FIG. 2, a sub-pixel SPij is illustrated, disposed on an i-th row (where i is an integer identical to or greater than 1 and identical to or less than m) and a j-th column (where j is an integer identical to or greater than 1 and identical to or less than n) among the sub-pixels SP of FIG. 1.

Referring to FIG. 2, the sub-pixel SPij may include a sub-pixel circuit SPC, a first light emitting element LD11, and a second light emitting element LD12.

The first light emitting element LD11 and the second light emitting element LD12 may be connected between a first power voltage node VDDN and a second power voltage node VSSN. The first light emitting element LD11 and the second light emitting element LD12 may be connected in series to each other. The first power voltage node VDDN may be connected to one of the power lines PL of FIG. 1 to receive a first power voltage. The second power voltage node VSSN may be connected to another one of the power lines PL of FIG. 1 to receive a second power voltage. The first power voltage may have a voltage level higher than the second power voltage.

The first light emitting element LD11 may be connected between a first anode electrode AE11 and a first cathode electrode CE11. The second light emitting element LD12 may be connected between a second anode electrode AE12 and a second cathode electrode CE2. The first cathode electrode CE11 and the second anode electrode AE12 may be electrically the same node. The first anode electrode AE11 may be connected to the first power voltage node VDDN through the sub-pixel circuit SPC. For example, the first anode electrode AE11 may be connected to the first power voltage node VDDN through one or more transistors included in the sub-pixel circuit SPC. The second cathode electrode CE2 may be connected to the second power voltage node VSSN. The first light emitting element LD11 and the second light emitting element LD12 may emit light according to current flowing from the first anode electrode AE11 to the second cathode electrode CE2.

The sub-pixel circuit SPC may be connected to an i-th gate line GLi among the first to m-th gate lines GL1 to GLm of FIG. 1 and may be connected to a j-th data line DLj among the first to n-th data lines DL1 to DLn of FIG. 1. In response to a gate signal received through the i-th gate line GLi, the sub-pixel circuit SPC may control the first light emitting element LD11 and the second light emitting element LD12 to emit light in response to a data signal received through the j-th data line DLj. In embodiments, the sub-pixel circuit SPC may be further connected to the pixel control lines PXCL of FIG. 1. For example, the sub-pixel circuit SPC may further control the first light emitting element LD11 and the second light emitting element LD12 in response to pixel control signals received through the pixel control lines PXCL.

For the sake of the aforementioned operations, the sub-pixel circuit SPC may include circuit elements, for example, transistors and at least one capacitor.

The transistors of the sub-pixel circuit SPC may include p-type transistors and/or N-type transistors. In embodiments, the transistors of the sub-pixel circuit SPC may include a metal oxide silicon field effect transistor (MOSFET). In embodiments, the transistors of the sub-pixel circuit SPC may include an amorphous silicon semiconductor, a monocrystalline silicon semiconductor, a polycrystalline silicon semiconductor, an oxide semiconductor, or the like.

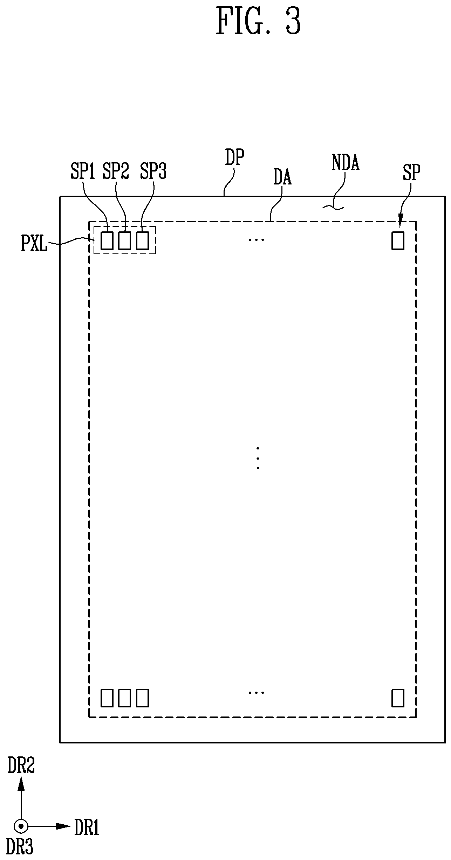

FIG. 3 is a plan view illustrating an embodiment of the display panel of FIG. 1.

Referring to FIG. 3, the display panel DP may include a display area DA and a non-display area NDA. The display panel DP may display an image through the display area DA. The non-display area NDA may be disposed around the display area DA.

The display panel DP may include sub-pixels SP in the display area DA. The sub-pixels SP may be arranged in a first direction DR1 and a second direction DR2 intersecting with the first direction DR1. For example, the sub-pixels SP may be arranged in the form of a matrix in the first direction DR1 and the second direction DR2. As another example, the sub-pixels SP may be arranged in a zigzag form in the first direction DR1 and the second direction DR2. The arrangement of the sub-pixels SP may be changed according to embodiments. The first direction DR1 may refer to a row direction, and the second direction DR2 may refer to a column direction.

Two or more sub-pixels among the sub-pixels SP may form one pixel PXL. Although FIG. 3 illustrates that the pixel PXL includes three sub-pixels SP1 to SP3, embodiments are not limited thereto. For example, the pixel PXL may include two sub-pixels. Hereinafter, for convenience of explanation, it is assumed that the pixel PXL includes first to third sub-pixels SP1 to SP3.

Each of the first to third sub-pixels SP1 to SP3 may generate light of one among various colors such as red, green, blue, cyan, magenta, and yellow. Hereinafter, for clear and concise description, it is assumed that the first sub-pixel SP1 generates red light, the second sub-pixel SP2 generates green light, and the third sub-pixel SP3 generates blue light.

Each of the first to third sub-pixels SP1 to SP3 may include at least one light emitting element that generates light. In embodiments, the light emitting elements of the first to third sub-pixels SP1 to SP3 may generate light in the same color. For example, the light emitting elements of the first to third sub-pixels SP1 to SP3 may generate blue light. In other embodiments, the light emitting elements of the first to third sub-pixels SP1 to SP3 may generate light in different colors. For example, the light emitting elements of the first to third sub-pixels SP1 to SP3 may respectively generate red light, green light, and blue light.

The display panel DP may include a self-luminous display panel such as an LED display panel using a micro-scale or nano-scale light emitting diode as a light emitting element, and an organic light emitting display panel (OLED panel) using an organic light emitting diode as a light emitting element.

Components for controlling the sub-pixels SP may be disposed in the non-display area NDA. Lines connected to the sub-pixels SP, for example, the first to m-th gate lines GL1 to GLm, the first to n-th data lines DL1 to DLn, the power lines PL, and the pixel control lines PXCL of FIG. 1, may be disposed in the non-display area NDA.

At least one of the gate driver 120, the data driver 130, the voltage generator 140, and the controller 150 of FIG. 1 may be disposed in the non-display area NDA of the display panel DP. In embodiments, the gate driver 120 may be disposed in the non-display area NDA. For example, the data driver 130, the voltage generator 140, and the controller 150 may be implemented as the driver integrated circuit DIC of FIG. 1 that is separated from the display panel DP. The driver integrated circuit DIC may be connected to the lines disposed in the non-display area NDA. In other embodiments, the gate driver 120 along with the data driver 130, the voltage generator 140, and the controller 150 may be implemented as a single integrated circuit that is separated from the display panel DP.

In embodiments, the display area DA may have various shapes. The display area DA may have a closed-loop shape including linear and/or curved sides. For example, the display area DA may have shapes such as polygons, circles, semicircles, ellipses, and the like.

In embodiments, the display panel DP may have a planar display surface. In embodiments, the display panel DP may have a display surface that is at least partially rounded. In embodiments, the display panel DP may be bendable, foldable, or rollable. In the aforementioned cases, the display panel DP and/or a substrate of the display panel DP may include materials having flexible properties.

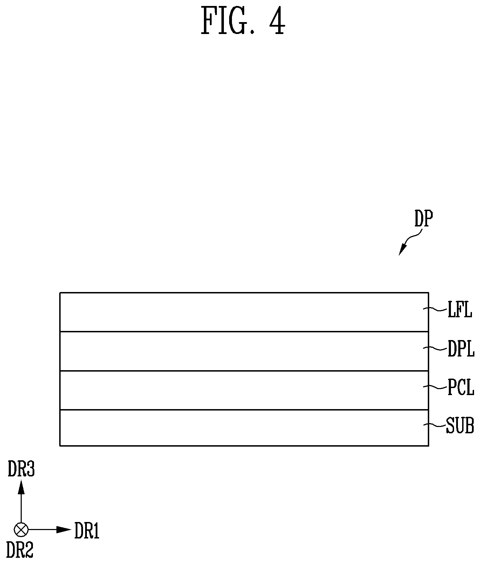

FIG. 4 is a cross-sectional view illustrating an embodiment of the display panel of FIG. 3.

Referring to FIG. 4, the display panel DP may include a substrate SUB, and a pixel circuit layer PCL, a display element layer DPL, and a light functional layer LFL that are sequentially stacked on the substrate SUB in a third direction DR3 intersecting with the first and second directions DR1 and DR2.

The substrate SUB may be made of an insulating material such as glass or resin. For example, the substrate SUB may include a glass substrate. As another example, the substrate SUB may include a polyimide (PI) substrate. As another example, the substrate SUB may include a silicon wafer substrate formed by a semiconductor process.

In embodiments, the substrate SUB may be made of a material having flexibility so as to be bendable or foldable, and may have a single-layer structure or a multilayer structure. For instance, the material having flexibility may include at least one of the following: polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polyimide, polycarbonate, triacetate cellulose, and cellulose acetate propionate. However, embodiments are not limited thereto.

The pixel circuit layer PCL may be disposed on the substrate SUB. The pixel circuit layer PCL may include insulating layers, and semiconductor patterns and conductive patterns disposed between the insulating layers. The conductive patterns of the pixel circuit layer PCL may function as circuit elements, lines, or the like.

The circuit elements of the pixel circuit layer PCL may include the respective sub-pixel circuits SPC (refer to FIG. 2) of the sub-pixels SP of FIG. 3. For example, the circuit elements of the pixel circuit layer PCL may be provided (or formed) as transistors and one or more capacitors of the sub-pixel circuit SPC.

The lines of the pixel circuit layer PCL may include lines connected to the sub-pixels SP. The lines of the pixel circuit layer PCL may include various signal lines and/or voltage lines needed to drive the display element layer DPL.

The display element layer DPL may be disposed on the pixel circuit layer PCL. The display element layer DPL may include light emitting elements of the sub-pixels SP.

The light functional layer LFL may be disposed on the display element layer DPL. The light functional layer LFL may include light conversion patterns having color conversion particles and/or scattering particles. For example, the color conversion particles may include quantum dots. The quantum dots may convert the wavelength (or color) of light emitted from the display element layer DPL. The light functional layer LFL may further include light scattering patterns having scattering particles. In another example, the light conversion patterns and the light scattering patterns may be omitted.

The light functional layer LFL may further include a color filter layer including color filters. Each of the color filters may selectively transmit light of a specific wavelength (or specific color). In another example, the color filter layer may be omitted.

A window may be provided on the light functional layer LFL to protect an exposed surface (or upper surface) of the display panel DP. The window may protect the display panel DP from an external impact. The window may be connected to the light functional layer LFL by an optically transparent adhesive (or bonding) agent. The window may have a multilayer structure selected from among a glass substrate, a plastic film, and a plastic substrate. The multilayer structure may be formed by a successive process or an adhesion process using an adhesive layer. The entirety or portion of the window may have flexibility.

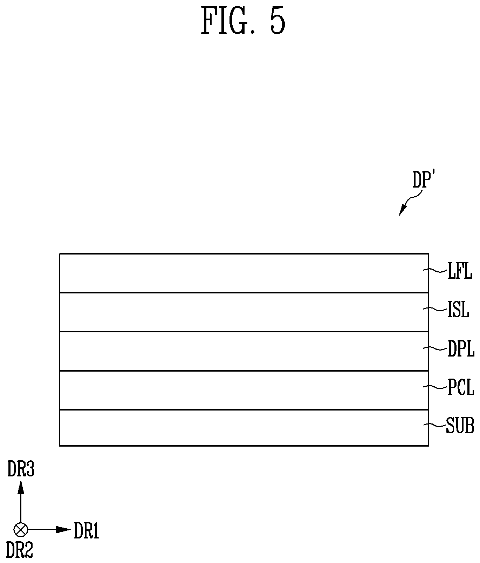

FIG. 5 is a cross-sectional view illustrating another embodiment of the display panel of FIG. 3.

Referring to FIG. 5, a display panel DP' may include a substrate SUB, a pixel circuit layer PCL, a display element layer DPL, an input sensing layer ISL, and a light functional layer LFL. The substrate SUB, the pixel circuit layer PCL, the display element layer DPL, and the light functional layer LFL may be formed in the same manner as the substrate SUB, the pixel circuit layer PCL, the display element layer DPL, and the light functional layer LFL that have been described with reference to FIG. 4. Hereinafter, redundant explanations will be omitted for descriptive convenience.

The input sensing layer ISL may sense a user input on an upper surface (or display surface) of the display panel DP'. The input sensing layer ISL may include components suitable for sensing an external object such as the hand of the user, a pen, or the like. For example, the input sensing layer ISL may include touch electrodes.

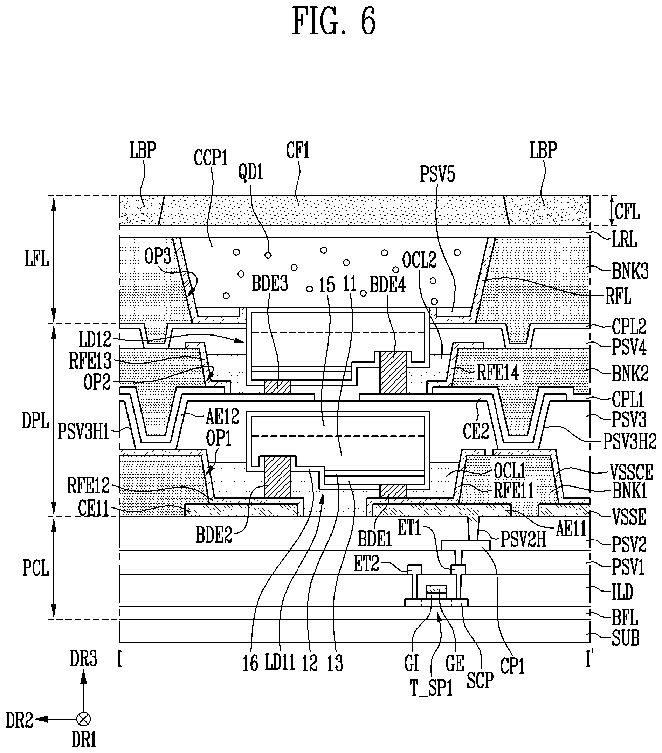

FIG. 6 is a cross-sectional view illustrating an embodiment of a sub-pixel.

Referring to FIG. 6, the pixel circuit layer PCL, the display element layer DPL, and the light functional layer LFL may be sequentially disposed on the substrate SUB.

The pixel circuit layer PCL may include insulating layers, semiconductor patterns, and conductive patterns that are stacked on the substrate SUB. The insulating layers may include a buffer layer BFL, one or more interlayer insulating layers ILD, and one or more passivation layers PSV1 and PSV2. The semiconductor patterns and the conductive patterns may be positioned between the insulating layers. The conductive patterns may include at least one material of copper (Cu), molybdenum (Mo), tungsten (W), aluminium-neodymium (AlNd), titanium (Ti), aluminium (Al), and silver (Ag).

As described with reference to FIG. 2, the sub-pixel circuit SPC (refer to FIG. 2) of each of the first to third sub-pixels SP1 to SP3 may include transistors and one or more capacitors. The semiconductor patterns and the conductive patterns included in the pixel circuit layer PCL may function as the transistors and the capacitors of the sub-pixel circuit SPC. Furthermore, the conductive patterns of the pixel circuit layer PCL may also function as lines, for example, the first to m-th gate lines GL1 to GLm, the first to n-th data lines DL1 to DLn, the power lines PL, and the pixel control lines PXCL of FIG. 1.

The buffer layer BFL may be disposed on a surface of the substrate SUB. The buffer layer BFL may prevent impurities from diffusing into the circuit elements and the lines that are included in the pixel circuit layer PCL. The buffer layer BFL may include an inorganic insulating layer including an inorganic material. In embodiments, the buffer layer BFL may include at least one of silicon nitride (SiNₓ), silicon oxide (SiOₓ), silicon oxynitride (SiOₓN_{y}), and metal oxide such as aluminium oxide (AlOₓ). The buffer layer BFL may be formed in a single layer or multiple layers. In the case that the buffer layer BFL is formed in a multilayer structure, the respective layers may be formed of the same material or different materials.

In embodiments, one or more barrier layers may be disposed between the substrate SUB and the buffer layer BFL. Each of the barrier layers may include polyimide.

A first transistor T_SP1 may be disposed on the buffer layer BFL. The first transistor T_SP1 may be any one of the transistors of the sub-pixel circuit SPC included in the first sub-pixel SP1. For example, the first transistor T_SP1 may be a transistor connected to the first anode electrode AE11 among the transistors of the sub-pixel circuit SPC.

The first transistor T_SP1 may include a semiconductor pattern SCP, a gate electrode GE, a first terminal ET1, and a second terminal ET2. The first terminal ET1 may be either a source electrode or a drain electrode, and the second terminal ET2 may be the other one of the source electrode and the drain electrode. For example, the first terminal ET1 may be a drain electrode, and the second terminal ET2 may be a source electrode.

The semiconductor pattern SCP may be disposed on the buffer layer BFL. The semiconductor pattern SCP may include a first contact region that contacts the first terminal ET1, and a second contact region that contacts the second terminal ET2. A region between the first contact region and the second contact region may be a channel region. The channel region may overlap the gate electrode GE of the first transistor T_SP1. The channel region may be a semiconductor pattern that is not doped with impurities, and may be an intrinsic semiconductor. Each of the first contact region and the second contact region may be a semiconductor pattern doped with impurities. The aforementioned impurities may include, for example, p-type impurities or n-type impurities, but embodiments are not limited thereto.

The semiconductor pattern SCP may include any one of various types of semiconductors, for example, an amorphous silicon semiconductor, a monocrystalline silicon semiconductor, a polycrystalline silicon semiconductor, a low temperature poly silicon semiconductor, and an oxide semiconductor.

The interlayer insulating layers ILD that are sequentially stacked may be disposed on the semiconductor pattern SCP. The interlayer insulating layers ILD may be formed of inorganic insulating layers including an inorganic material. For example, each of the interlayer insulating layers ILD may include at least one of silicon nitride (SiNₓ), silicon oxide (SiOₓ), silicon oxynitride (SiOₓN_{y}), and metal oxide such as aluminium oxide (AlOₓ). However, the material of the interlayer insulating layers ILD is not limited thereto. For example, any one of the interlayer insulating layers ILD may include an organic insulating layer including an organic material.

The interlayer insulating layers ILD may electrically separate the conductive patterns and/or semiconductor patterns that are disposed between the interlayer insulating layers ILD from each other. For example, the interlayer insulating layers ILD may include a gate insulating layer GI disposed on the semiconductor pattern SCP. The gate insulating layer GI may be disposed between the semiconductor pattern SCP and the gate electrode GE such that the gate electrode GE may be spaced apart from the semiconductor pattern SCP. In embodiments, the gate insulating layer GI may be disposed on the overall surfaces of the semiconductor pattern SCP and the buffer layer BFL, thereby covering the semiconductor pattern SCP and the buffer layer BFL. As the number of layers for forming the conductive patterns and/or the semiconductor patterns increases, the number of interlayer insulating layers ILD may increase.

The gate electrode GE may be disposed on the gate insulating layer GI. The gate electrode GE may overlap the channel region of the semiconductor pattern SCP. In embodiments, the gate electrode GE may be formed in a single layer structure including at least one material of copper (Cu), molybdenum (Mo), tungsten (W), aluminium-neodymium (AlNd), titanium (Ti), aluminium (Al), and silver (Ag). In embodiments, the gate electrode GE may be formed in a multilayer structure including at least one material of molybdenum (Mo), titanium (Ti), aluminium (Al), and silver (Ag) that are low-resistance materials.

The first and second terminals ET1 and ET2 may be disposed on the interlayer insulating layers ILD. The first and second terminals ET1 and ET2 may contact the semiconductor pattern SCP through contact holes passing through the interlayer insulating layers ILD. The first and second terminals ET1 and ET2 may respectively contact the first and second contact regions of the semiconductor pattern SCP. Each of the first and second terminals ET1 and ET2 may include at least one material of copper (Cu), molybdenum (Mo), tungsten (W), aluminium-neodymium (AlNd), titanium (Ti), aluminium (Al), and silver (Ag).

Although the first and second terminals ET1 and ET2 are illustrated as separate electrodes electrically connected to the semiconductor pattern SCP, embodiments are not limited thereto. In embodiments, the first terminal ET1 may be a first contact region adjacent to a side of the channel region of the semiconductor pattern SCP, and the second terminal ET2 may be a second contact region adjacent to the other side of the channel region. For example, the first terminal ET1 may be electrically connected to the light emitting element LD through a connection unit such as a bridge electrode disposed on at least one of the interlayer insulating layers ILD.

In embodiments, the first transistor T_SP1 may be formed as a low-temperature polysilicon transistor. However, embodiments are not limited thereto. For example, the first transistor T_SP1 may be formed as an oxide semiconductor transistor. In embodiments, the sub-pixel circuit SPC of the first sub-pixel SP1 may include different types of transistors. For example, the first transistor T_SP1 may be formed as a low-temperature polysilicon transistor. Another transistor of the first sub-pixel SP1 may be formed as an oxide semiconductor transistor. For example, an oxide semiconductor of the corresponding oxide semiconductor transistor may be disposed on any one of the interlayer insulating layers ILD rather than on an insulating layer on which the semiconductor pattern SCP of the first transistor T_SP1 is disposed.

Although in the embodiments there has been described the case where the first transistor T_SP1 has a top gate structure, the embodiments are not limited thereto. For example, the first transistor T_SP1 may be a transistor having a bottom gate structure. For example, the structure of the first transistor T_SP1 may be changed in various ways.

The display panel DP and/or at least some of various lines of the display device DD may be further disposed on the interlayer insulating layers ILD.

A first passivation layer PSV1 may be disposed on the interlayer insulating layers ILD and the first and second terminals ET1 and ET2. The passivation layer may be referred to as a protective layer or a via layer. The first passivation layer PSV1 may protect components disposed thereunder and provide a flat upper surface.

A connection pattern CP1 may be disposed on the first passivation layer PSV1. The connection pattern CP1 may pass through the first passivation layer PSV1 and be connected to the first terminal ET1 of the transistor T_SP1. The connection pattern CP1 may include at least one material of copper (Cu), molybdenum (Mo), tungsten (W), aluminium-neodymium (AlNd), titanium (Ti), aluminium (Al), and silver (Ag).

The display panel DP and/or at least some of various lines of the display device DD may be further disposed on the first passivation layer PSV1.

A second passivation layer PSV2 may be disposed on the connection pattern CP1 and the first passivation layer PSV1. The second passivation layer PSV2 may protect components disposed thereunder and provide a flat upper surface.

Each of the first and second passivation layers PSV1 and PSV2 may include an inorganic insulating layer including an inorganic material, and/or an organic insulating layer including an organic material. The inorganic insulating layer may include, for example, at least one of silicon oxide (SiOₓ), silicon nitride (SiNₓ), silicon oxynitride (SiOₓN_{y}), and metal oxide such as aluminium oxide (AlOₓ). The organic insulating layer may include, for example, at least one of acrylic resin, epoxy resin, phenol resin, polyamide resin, polyimide rein, unsaturated polyester resin, poly-phenylen ether resin, poly-phenylene sulfide resin, and benzocyclobutene resin.

The first and second passivation layers PSV1 and PSV2 may include the same material as any one of the interlayer insulating layers ILD, but the embodiments are not limited thereto. Each of the first and second passivation layers PSV1 and PSV2 may be formed in a single-layer structure.

The display element layer DPL may be disposed on the second passivation layer PSV2. The display element layer DPL may include the first anode electrode AE11, the first cathode electrode CE11, a common electrode VSSE, a first bank BNK1, first and second reflective electrodes RFE11 and RFE12, a common connection electrode VSSCE, the first light emitting element LD11, a first overcoat layer OCL1, a third passivation layer PSV3, the second anode electrode AE12, the second cathode electrode CE2, a first capping layer CPL1, a second bank BNK2, third and fourth reflective electrodes RFE13 and RFE14, a second overcoat layer OCL2, a fourth passivation layer PSV4, and a second capping layer CPL2.

The first anode electrode AE11, the first cathode electrode CE11, and the common electrode VSSE may be disposed on the pixel circuit layer PCL.

The first anode electrode AE11 may be connected to the connection pattern CP1 through a contact hole PSV2H passing through the second passivation layer PSV2. The first anode electrode AE11 may be positioned to overlap the contact hole PSV2H. The first anode electrode AE11 may be electrically connected to the first terminal ET1 of the first transistor T_SP1. In an embodiment where the first passivation layer PSV1 is unnecessary, the first anode electrode AE11 may be directly connected to the first terminal ET1 of the first transistor T_SP1.

The first cathode electrode CE11 may be spaced apart from the first anode electrode AE11 in the second direction DR2. The first cathode electrode CE11 may be connected to a corresponding single sub-pixel circuit SPC.

The common electrode VSSE may be spaced apart from the first anode electrode AE11 in a direction opposite to the second direction DR2. The common electrode VSSE may be connected in common to a plurality of sub-pixel circuits SPC. The common electrode VSSE may be electrically connected to the second power voltage node VSSN of FIG. 2. Accordingly, a second power voltage applied to the second power voltage node VSSN may be transmitted to the common electrode VSSE.

The first bank BNK1 may be disposed on the first anode electrode AE11, the first cathode electrode CE11, and the common electrode VSSE. The first bank BNK1 may have a first opening OP1 through which a portion of the first anode electrode AE11 and a portion of the first cathode electrode CE11 are exposed. Furthermore, the first bank BNK1 may further include an opening through which a portion of the common electrode VSSE is exposed. The first light emitting element LD11 may be disposed in the first opening OP1 of the first bank BNK1. For example, the first bank BNK1 may be provided as a pixel defining layer that defines an area where the first light emitting element LD11 is positioned.

The first bank BNK1 may include a light blocking material to prevent light mixture between adjacent sub-pixels. In embodiments, the first bank BNK1 may include an organic material. For example, the first bank BNK1 may include an organic insulating material made of a material such as acryl resin, epoxy resin, phenol resin, polyamide resin, polyimide resin, or the like.

The first reflective electrode RFE11 may be disposed on an exposed portion of the first anode electrode AE11 and a side surface of the first bank BNK1 adjacent to the first reflective electrode RFE11. The first reflective electrode RFE11 may be positioned on the first anode electrode AE11 and the first bank BNK1, and may connect a first bonding electrode BDE1 and the first anode electrode AE11. The second reflective electrode RFE12 may be disposed on an exposed portion of the first cathode electrode CE11 and a side surface of the first bank BNK1 adjacent to the second reflective electrode RFE12. The second reflective electrode RFE12 may be positioned on the first cathode electrode CE11 and the first bank BNK1, and may connect a second bonding electrode BDE2 and the first cathode electrode CE11. The common connection electrode VSSCE may be disposed on the first bank BNK1 and the common electrode VSSE, and may be connected to the second cathode electrode CE2. The common connection electrode VSSCE may be connected in common to a plurality of sub-pixel circuits.

The first and second reflective electrodes RFE1 and RFE2 and the common connection electrode VSSCE may include conductive materials suitable for reflecting light. Consequently, the light output efficiency of the first light emitting element LD11 may be enhanced. In embodiments, the first and second reflective electrodes RFE11 and RFE12 and the common connection electrode VSSCE may include at least one of aluminium (Al), silver (Ag), magnesium (Mg), platinum (Pt), palladium (Pd), gold (Au), nickel (Ni), neodymium (Nd), iridium (Ir), chromium (Cr), titanium (Ti), and an alloy of two or more materials selected from among the aforementioned materials. However, embodiments are not limited thereto.

The first light emitting element LD11 may be electrically connected to the first anode electrode AE11 through the first reflective electrode RFE11. The first light emitting element LD11 may be electrically connected to the first cathode electrode CE11 through the second reflective electrode RFE12. The first light emitting element LD11 may be bonded to the first and second reflective electrodes RFE11 and RFE12.

The first light emitting element LD11 may include a first semiconductor layer 11, an active layer 12, a second semiconductor layer 13, and an auxiliary layer 15. The first light emitting element LD11 may include an emission stack in which the auxiliary layer 15, the first semiconductor layer 11, the active layer 12, and the second semiconductor layer 13 are sequentially stacked.

The first light emitting element LD11 may include first and second bonding electrodes BDE1 and BDE2 oriented in the same direction (e.g., in a direction opposite to the third direction DR3). The first bonding electrode BDE1 may be connected to the second semiconductor layer 13. The second bonding electrode BDE2 may be connected to the first semiconductor layer 11 exposed by etching the second semiconductor layer 13 and the active layer 12. The first light emitting element LD11 may be a flip-chip-type light emitting element.

The first semiconductor layer 11 may provide electrons to the active layer 12. The first semiconductor layer 11 may include, for example, at least one n-type semiconductor layer. For example, the first semiconductor layer 11 may include any one semiconductor material among gallium nitride (GaN), aluminium gallium nitride (AlGaN), indium gallium nitride (InGaN), aluminium nitride (AlN), and indium nitride (InN), and may be an n-type semiconductor layer doped with a first conductive dopant (or n-type dopant) such as silicon (Si), germanium (Ge), or tin (Sn). However, the material for forming the first semiconductor layer 11 is not limited thereto, and various other materials may be used to form the first semiconductor layer 11. In an embodiment, the first semiconductor layer 11 may include a gallium nitride (GaN) semiconductor material doped with a first conductive dopant (or an n-type dopant). In an embodiment, the first semiconductor layer 11 along with the auxiliary layer 15 may form an n-type semiconductor layer.

The active layer 12 may be disposed on the first semiconductor layer 11, and may be an area where electrons and holes are recombined with each other. As electrons and holes are recombined with each other in the active layer 12, the electrons and holes may make a transition to a low energy level. Thus, light having a corresponding wavelength may be generated. The active layer 12 may have a single-quantum well structure or multi-quantum well structure. In the case that the active layer 12 is formed to have a multi-quantum well structure, units each including a barrier layer, a strain reinforcing layer, and a well layer may be repeatedly stacked to form the active layer 12. However, embodiments of the active layer 12 are not limited thereto.

The second semiconductor layer 13 may be disposed on the active layer 12, and may provide holes to the active layer 12. The second semiconductor layer 13 may include a semiconductor layer of a type different from the first semiconductor layer 11. For example, the second semiconductor layer 13 may include at least one p-type semiconductor layer. For example, the second semiconductor layer 13 may include at least one semiconductor material among gallium nitride (GaN), aluminium gallium nitride (AlGaN), indium gallium nitride (InGaN), aluminium nitride (AlN), and indium nitride (InN), and may be a p-type semiconductor layer doped with a second conductive dopant (or p-type dopant) such as magnesium (Mg), zinc (Zn), calcium (Ca), strontium (Sr), barium (Ba), or the like. However, the material for forming the second semiconductor layer 13 is not limited thereto, and various other materials may be used to form the second semiconductor layer 13. In an embodiment, the second semiconductor layer 13 may include a gallium nitride (GaN) semiconductor material doped with a second conductive dopant (or a p-type dopant).

The auxiliary layer 15 may include undoped gallium nitride (GaN) semiconductor material, and may form an n-type semiconductor layer along with the first semiconductor layer 11.

The first bonding electrode BDE1 may be electrically connected to the second semiconductor layer 13. The second bonding electrode BDE2 may be electrically connected to the first semiconductor layer 11. The first and second bonding electrodes BDE1 and BDE2 may include a eutectic metal.

The first light emitting element LD1 may further include an insulating layer 16 provided to cover a circumferential outer surface of the emission stack. The insulating layer 16 may prevent the active layer 12 from short-circuiting due to contact with other conductive material other than the first and second semiconductor layers 11 and 13. The insulating layer 16 may include a transparent insulating material. The insulating layer 16 may expose lower surfaces of the first and second bonding electrodes BDE1 and BDE2.

The lower surface of the first bonding electrode BDE1 may contact the first reflective electrode RFE11. Accordingly, the first bonding electrode BDE1 may be electrically connected to the first anode electrode AE11 through the first reflective electrode RFE11. For example, the first bonding electrode BDE1 may be electrically connected to the first terminal ET1 of the first transistor T_SP1 positioned in the pixel circuit layer PCL. The lower surface of the second bonding electrode BDE2 may contact the second reflective electrode RFE12. Accordingly, the second bonding electrode BDE2 may be electrically connected to the first cathode electrode CE11 through the second reflective electrode RFE12.

The first overcoat layer OCL1 may be disposed in the first opening OP1 in which the first and second reflective electrodes RFE11 and RFE12 and the first light emitting element LD11 are disposed. The first overcoat layer OCL1 may fix the first light emitting element LD11 bonded to the first and second reflective electrodes RFE11 and RFE12, thereby preventing movement. Furthermore, the first overcoat layer OCL1 may protect components disposed thereunder from foreign substances such as dust and water. For example, the first overcoat layer OCL1 may include at least one of an inorganic insulating layer and an organic insulating layer. For example, the first overcoat layer OCL1 may include epoxy, but the embodiments are not limited thereto.

The third passivation layer PSV3 may be disposed on the first bank BNK1, the first overcoat layer OCL1, and the first light emitting element LD11. The third passivation layer PSV3 may protect components disposed thereunder and provide an even (or flat) upper surface. The third passivation layer PSV3 may include the same material as any one of the first and second passivation layers PSV1 and PSV2, but the embodiments are not limited thereto.

Contact holes PSV3H1 and PSVH2 may be formed in the third passivation layer PSV3. The contact hole PSV3H1 may expose the second reflective electrode RFE12. The contact hole PSV3H2 may expose the common connection electrode VSSCE.

The second anode electrode AE12 and the second cathode electrode CE2 may be disposed on the third passivation layer PSV3. The second anode electrode AE12 may be disposed to overlap the contact hole PSV3H1 and contact the second reflective electrode RFE12. The second cathode electrode CE2 may be disposed to overlap the contact hole PSV3H2 and contact the common connection electrode VSSCE. The second cathode electrode CE2 may be connected in common to a plurality of sub-pixel circuits. For example, each of the second anode electrode AE12 and the second cathode electrode CE2 may be formed of a transparent conductor such as ITO, IZO, ZnO, or ITZO. In another embodiment, each of the second anode electrode AE12 and the second cathode electrode CE2 may be formed of an opaque conductor. For example, each of the second anode electrode AE12 and the second cathode electrode CE2 may include at least one material of copper (Cu), molybdenum (Mo), tungsten (W), aluminium-neodymium (AlNd), titanium (Ti), aluminium (Al), and silver (Ag).

The first capping layer CPL1 may be disposed on the third passivation layer PSV3, the second anode electrode AE12, and the second cathode electrode CE2. The first capping layer CPL1 may protect components disposed under the first capping layer CPL1 from external water, moisture, or the like. The first capping layer CPL1 may include at least one of silicon nitride (SiNₓ), silicon oxide (SiOₓ), silicon oxynitride (SiOₓN_{y}), and metal oxide such as aluminium oxide (AlOₓ). However, the material of the first capping layer CPL1 is not limited thereto.

The second bank BNK2 may be disposed on the first capping layer CPL1. The second bank BNK2 may overlap the first bank BNK1. The second bank BNK2 may have a second opening OP2 at least a portion of which overlaps the first opening OP1.

The second bank BNK2 may include a light blocking material to prevent light mixture between adjacent sub-pixels. The second bank BNK2 may be made of a material identical or similar to the first bank BNK1.

The third reflective electrode RFE13 may be disposed both on a portion of the first capping layer CPL1 exposed through the second opening OP2 and on a side surface of the second bank BNK2 adjacent to the third reflective electrode RFE13. The fourth reflective electrode RFE14 may be disposed both on a portion of the first capping layer CPL1 exposed through the second opening OP2 and on a side surface of the second bank BNK2 adjacent to the fourth reflective electrode RFE14. The third and fourth reflective electrodes RFE13 and RFE14 may be made of a material identical or similar to the first and second reflective electrodes RFE11 and RFE12. Consequently, the light output efficiency of the second light emitting element LD12 may be enhanced.

The third and fourth reflective electrodes RFE13 and RFE14 may not cover the second anode electrode AE12 and the second cathode electrode CE2 that are exposed through the second opening OP2. In another embodiment, the third and fourth reflective electrodes RFE13 and RFE14 may only minimally cover the second anode electrode AE12 and the second cathode electrode CE2 that are exposed through the second opening OP2. Therefore, the extent to which light emitted from the first light emitting element LD11 is blocked by the third and fourth reflective electrodes RFE13 and RFE14 may be minimized.

The second light emitting element LD12 may be disposed in the second opening OP2. The second light emitting element LD12 may have a configuration identical or similar to the first light emitting element LD11. For example, a third bonding electrode BDE3 of the second light emitting element LD12 may correspond to the first bonding electrode BDE1 of the first light emitting element LD11. Furthermore, a fourth bonding electrode BDE4 of the second light emitting element LD12 may correspond to the second bonding electrode BDE2 of the first light emitting element LD11. In the following descriptions of the second light emitting element LD12, redundant descriptions provided for the first light emitting element LD11 will be omitted for descriptive convenience.

The third bonding electrode BDE3 of the second light emitting element LD12 may be connected to the second anode electrode AE12. The third bonding electrode BDE3 may be electrically connected to the second bonding electrode BDE2. For example, the third bonding electrode BDE3 may be connected to the second bonding electrode BDE2 through the second anode electrode AE12 and the second reflective electrode RFE12.

The fourth bonding electrode BDE4 of the second light emitting element LD12 may be connected to the second cathode electrode CE2. The fourth bonding electrode BDE4 may be electrically connected to the common electrode VSSE. For example, the fourth bonding electrode BDE4 may be connected to the common electrode VSSE through the second cathode electrode CE2 and the common connection electrode VSSCE.

The second overcoat layer OCL2 may be disposed in the second opening OP2 in which the third and fourth reflective electrodes RFE13 and RFE14 and the second light emitting element LD12 are disposed. The second overcoat layer OCL2 may fix the second light emitting element LD12 bonded to the second anode electrode AE12 and the second cathode electrode CE2, thereby preventing movement. Furthermore, the second overcoat layer OCL2 may protect components disposed thereunder from foreign substances such as dust and water. For example, the second overcoat layer OCL2 may include at least one of an inorganic insulating layer and an organic insulating layer. For example, the second overcoat layer OCL2 may include epoxy, but the embodiments are not limited thereto.

The fourth passivation layer PSV4 may be disposed on the second bank BNK2, the second overcoat layer OCL2, and the second light emitting element LD12. The fourth passivation layer PSV4 may protect components disposed thereunder and provide a flat upper surface. The fourth passivation layer PSV4 may include the same material as any one of the first to third passivation layers PSV1, PSV2, and PSV3, but the embodiments are not limited thereto.

In an embodiment, contact holes or trenches may be formed in the fourth passivation layer PSV4. The contact holes or trenches may expose portions of the second bank BNK2. For example, light blocking materials of a third bank BNK3 with which the contact holes or the trenches are filled may more effectively prevent light mixture between adjacent sub-pixels.

In embodiments, the fourth passivation layer PSV4 may not be disposed on an upper portion of the second light emitting element LD12. The upper portion of the second light emitting element LD12 may protrude into the light functional layer LFL. The second light emitting element LD12 may be positioned at least partially in a third opening OP3 of the third bank BNK3. For example, a height of the upper portion of the second light emitting element LD12 from the substrate SUB may be higher than that of a lowermost portion of a reflective layer RFL. Accordingly, light emitted from the second light emitting element LD12 may be provided to the light functional layer LFL at a relatively high rate.

The second capping layer CPL2 may be disposed on the fourth passivation layer PSV4. The second capping layer CPL2 may protect components disposed under the second capping layer CPL2 from external water, moisture, or the like. In embodiments, the second capping layer CPL2 may not be disposed on the upper portion of the second light emitting element LD12. In other embodiments, the second capping layer CPL2 may cover overall surfaces of the second light emitting element LD12 and the fourth passivation layer PSV4. The second capping layer CPL2 may include at least one of silicon nitride (SiNₓ), silicon oxide (SiOₓ), silicon oxynitride (SiOₓN_{y}), and metal oxide such as aluminium oxide (AlOₓ). However, the material of the second capping layer CPL2 is not limited thereto.

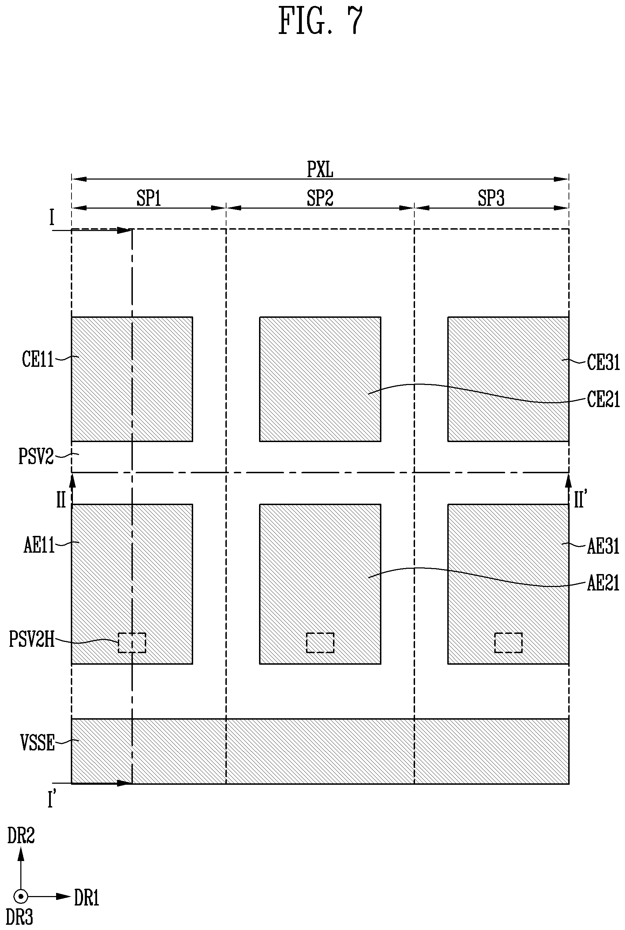

For example, the pixel circuit layer PCL and the display element layer DPL of the first sub-pixel SP1 have been described. Each of the second and third sub-pixels SP2 and SP3 to be described later may also be formed in the same manner as the first sub-pixel SP1 unless otherwise described (refer to FIGS. 7 to 14).

The light functional layer LFL may be disposed on the second capping layer CPL2. The light functional layer LFL may include the third bank BNK3, the reflective layer RFL, a fifth passivation layer PSV5, a first light conversion pattern CCP1, a low refractive layer LRL, and a color filter layer CFL.

The third bank BNK3 may be disposed on the second capping layer CPL2. The third bank BNK3 may overlap the second bank BNK2. The third bank BNK3 may have the third opening OP3 at least a portion of which overlaps the second opening OP2.

The third bank BNK3 may include a light blocking material to prevent light mixture between adjacent sub-pixels. In embodiments, the third bank BNK3 may include an organic material. For example, the third bank BNK3 may include an organic insulating material made of a material such as acryl resin, epoxy resin, phenol resin, polyamide resin, polyimide resin, or the like.

The reflective layer RFL may be disposed on sidewalls of the third bank BNK3 adjacent to the third opening OP3. The reflective layer RFL may reflect incident light, thereby enhancing the light output efficiency. The reflective layer RFL may include a material suitable for reflecting light. The reflective layer RFL may include at least one of aluminium (Al), silver (Ag), magnesium (Mg), platinum (Pt), palladium (Pd), gold (Au), nickel (Ni), neodymium (Nd), iridium (Ir), chromium (Cr), titanium (Ti), and an alloy of two or more materials selected from among the aforementioned materials. However, embodiments are not limited thereto. In an embodiment, the reflective layer RFL may cover the second capping layer CPL2 exposed through the third opening OP3.

The fifth passivation layer PSV5 may be disposed on the second capping layer CPL2 or the reflective layer RFL in the third opening OP3. The fifth passivation layer PSV5 may protect components disposed thereunder and provide a flat upper surface. The fifth passivation layer PSV5 may include the same material as any one of the first to fourth passivation layers PSV1 to PSV4, but the embodiments are not limited thereto.

The first light conversion pattern CCP1 may be disposed on the fifth passivation layer PSV5 in the third opening OP3. In an embodiment, the fifth passivation layer PSV5 may not cover the second light emitting element LD12. Consequently, the light output efficiency of the second light emitting element LD12 may be enhanced. In an embodiment, a height of an upper surface of the fifth passivation layer PSV5 may be equal to a height of an upper surface of the second light emitting element LD12.

The first light conversion pattern CCP1 may include color conversion particles and/or scattering particles. The color conversion particles may change the wavelength of incident light and convert the incident light into light in a different color. Furthermore, the color conversion particles may scatter incident light. In embodiments, the color conversion particles may be quantum dots. The scattering particles may scatter incident light.

The first sub-pixel SP1 may be a red sub-pixel. In the case where the first light emitting element LD1 emits blue light, the first light conversion pattern CCP1 may include first color conversion particles QD1 that convert blue light into red light. In the case where the first light emitting element LD1 emits red light, the first light conversion pattern CCP1 may include scattering particles. For example, particles included in the first light conversion pattern CCP1 may be changed in various ways according to the type of the first light emitting element LD1.

The low refractive layer LRL may be disposed on the third bank BNK3, the reflective layer RFL, and the first light conversion pattern CCP1. The low refractive layer LRL may have a refractive index lower than the first light conversion pattern CCP1 and a first color filter CF1. The low refractive layer LRL may refract or totally reflect incident light according to an incident angle of the corresponding light. For example, the low refractive layer LRL may provide light passing through the first light conversion pattern CCP1 to the first light conversion pattern CCP1 again. Accordingly, the light conversion efficiency of the first light conversion pattern CCP1 may be improved.

The color filter layer CFL may be disposed on the low refractive layer LRL. The color filter layer CFL may include the first color filter CF1 and light blocking patterns LBP. The first color filter CF1 may overlap the first light conversion pattern CCP1. The first color filter CF1 may selectively pass light in a selected wavelength range therethrough. In the case where the first sub-pixel SP1 is a red sub-pixel, the first color filter CF1 may include a red color filter. The light blocking patterns LBP may include at least one of various kinds of light blocking materials.

In accordance with the embodiment, two light emitting elements LD11 and LD12 may be connected in series to a single sub-pixel circuit SPC. Hence, the display device DD may emit light of a relatively high luminance based on the same current. For example, relatively low current may be required to emit light of the same luminance. As a result, an additional effect of reducing power consumption and heat generation may be obtained (or achieved). Furthermore, in the case where a pulse width modulation (PWM) circuit is applied to the sub-pixel circuit SPC, an increase in duty ratio may be possible, which is advantageous for low grayscale expression.

Furthermore, the light emitting elements LD11 and LD12 connected in series may be stacked in a vertical direction (e.g., in the third direction DR3). Thus, space on a plane may be saved. Therefore, the display area DA may have minimized dead space and a relatively high resolution.

Although, in the embodiment, two light emitting elements LD11 and LD12 stacked and connected in series are provided for illustrative purposes, the display device DD in accordance with another embodiment may include three or more light emitting elements stacked and connected in series.

FIGS. 7 to 13 are diagrams for describing a method of fabricating a pixel including the sub-pixel of FIG. 6.

Referring to FIGS. 7 to 13, the pixel PXL may include first to third sub-pixels SP1 to SP3. FIG. 6 is a cross-sectional view taken along line I-I' crossing the first sub-pixel SP1.

The first to third sub-pixels SP1 to SP3 may be arranged in the first direction DR1. However, the arrangement of the pixel PXL is not limited thereto, and may be changed in various ways according to the embodiments. For example, the first to third sub-pixels SP1 to SP3 may be arranged in a zigzag pattern.

Referring to FIG. 7, contact holes PSV2H may be formed in the second passivation layer PSV2 of the pixel circuit layer PCL. Thereafter, first anode electrodes AE11, AE21, and AE31, first cathode electrodes CE11, CE21, and CE31, and the common electrode VSSE may be formed on the second passivation layer PSV2.

The first anode electrodes AE11, AE21, and AE31 may be positioned to overlap the corresponding contact holes PSV2H. Therefore, the first anode electrode AE11 may be connected to the sub-pixel circuit SPC of the first sub-pixel SP1. For example, the first anode electrode AE21 may be connected to the sub-pixel circuit SPC of a second sub-pixel SP2. The first anode electrode AE31 may be connected to the sub-pixel circuit SPC of a third sub-pixel SP3.

The first cathode electrodes CE11, CE21, and CE31 may be positioned in the second direction DR2 from the corresponding first anode electrodes AE11, AE21, and AE31. The common electrode VSSE may be positioned in a direction opposite to the second direction DR2 from the first anode electrodes AE11, AE21, and AE31.

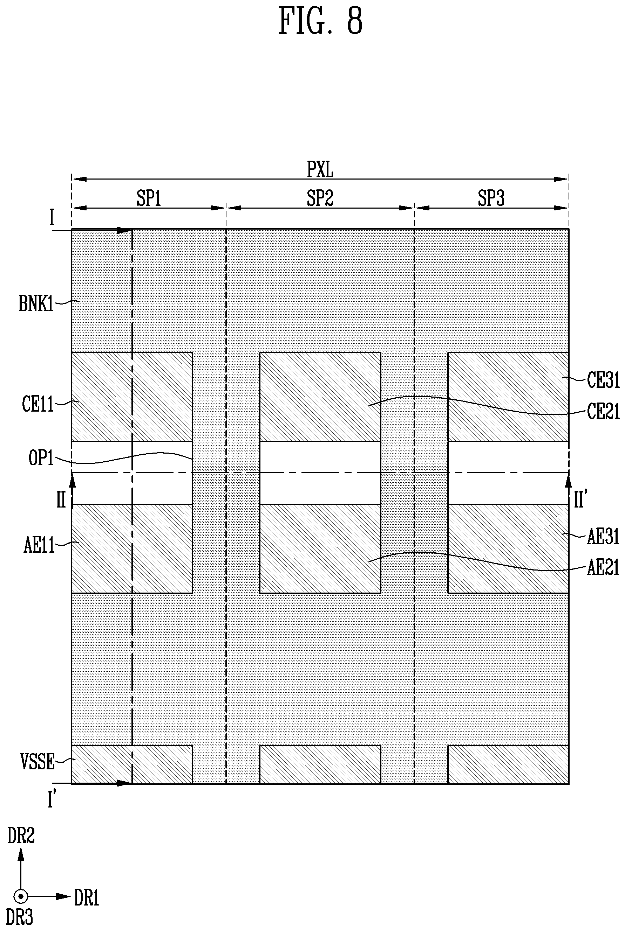

Referring to FIG. 8, the first bank BNK1 including first openings OP1 may be formed. A single first opening OP1 may be formed for each of the sub-pixels SP1 to SP3. The first openings OP1 may expose portions of the corresponding first cathode electrodes CE11, CE21, and CE31 and portions of the corresponding first anode electrodes AE11, AE21, and AE31. The first bank BNK1 may further include openings through which portions of the common electrode VSSE are exposed.

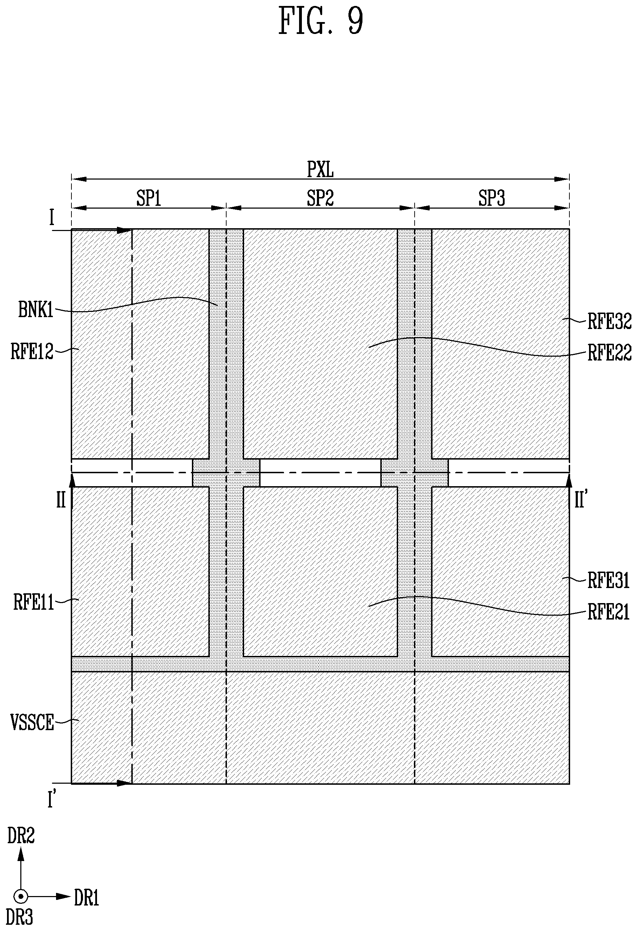

Referring to FIG. 9, first reflective electrodes RFE11, RFE21, and RFE31, second reflective electrodes RFE12, RFE22, and RFE32, and the common connection electrode VSSCE may be formed. The first reflective electrodes RFE11, RFE21, and RFE31 may be positioned on the first bank BNK1 and the corresponding first anode electrodes AE11, AE21, and AE31. The second reflective electrodes RFE12, RFE22, and RFE32 may be positioned on the first bank BNK1 and the corresponding first cathode electrodes CE11, CE21, and CE31. The common connection electrode VSSCE may be positioned on the first bank BNK1 and the common electrode VSSE.

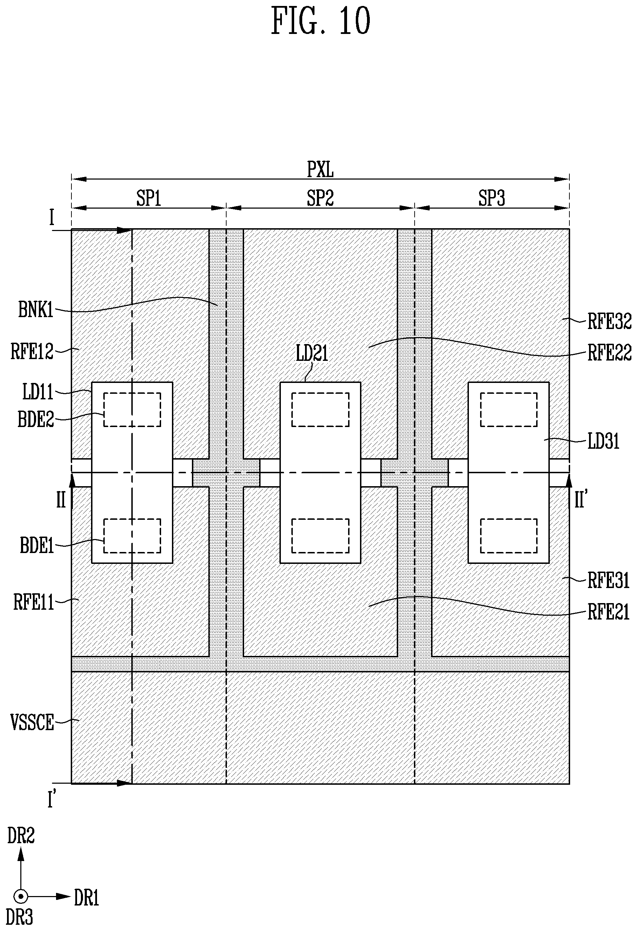

Referring to FIG. 10, first light emitting elements LD11, LD21, and LD31 may be positioned in the corresponding first openings OP1. For example, the first bonding electrode BDE1 of the first light emitting element LD11 of the first sub-pixel SP1 may be positioned on the first reflective electrode RFE11, and the second bonding electrode BDE2 of the first light emitting element LD11 may be positioned on the second reflective electrode RFE12. The first light emitting element LD21 of the second sub-pixel SP2 and the first light emitting element LD31 of the third sub-pixel SP3 may also be positioned in the same manner.

The first light emitting elements LD11, LD21, and LD31 may be inorganic light emitting diodes including an inorganic light emitting material. However, the embodiments are not limited thereto and, for example, organic light emitting diodes may be used.

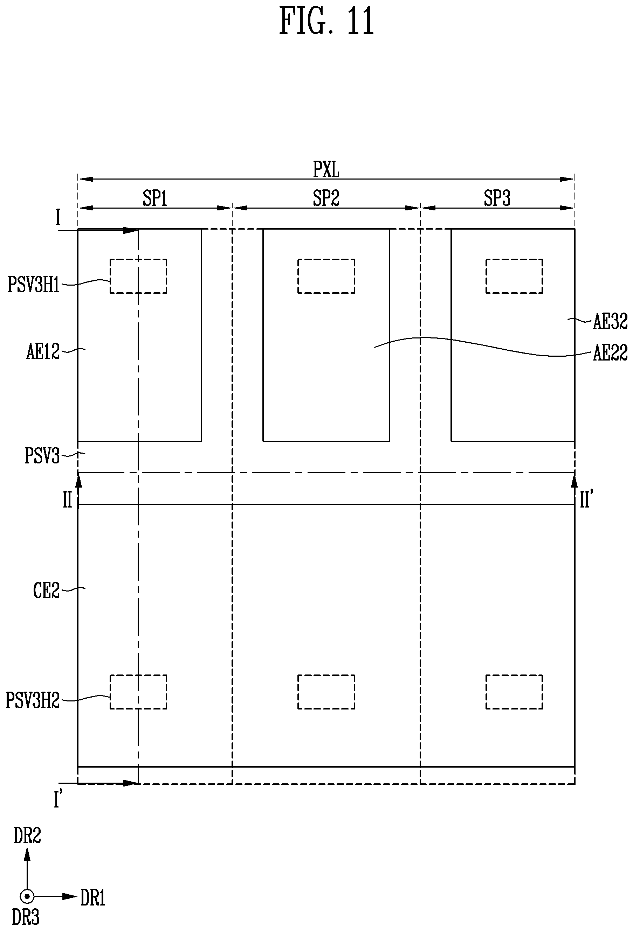

Referring to FIG. 11, the third passivation layer PSV3 may be formed on the first light emitting elements LD11, LD21 and LD31. Furthermore, contact holes PSV3H1 through which the second reflective electrodes RFE12, RFE22, and RFE32 are exposed and contact holes PSV3H2 through which the common connection electrode VSSCE is exposed may be formed on the third passivation layer PSV3.

Next, the second anode electrodes AE12, AE22, and AE32 and the second cathode electrode CE2 may be formed on the third passivation layer PSV3. The second anode electrodes AE12, AE22, and AE32 may be positioned to overlap the contact holes PSV3H1. The second cathode electrode CE2 may be positioned to overlap the contact hole PSV3H2.

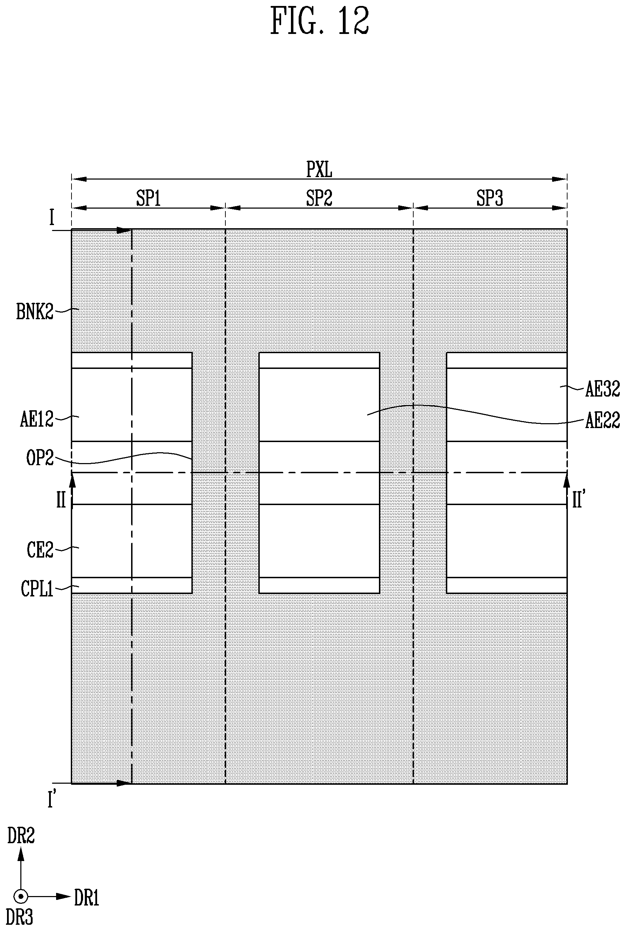

Referring to FIG. 12, the first capping layer CPL1 may be formed, and the second bank BNK2 may be formed on the first capping layer CPL1. The second bank BNK2 may include second openings OP2. A single second opening OP2 may be formed for each of the sub-pixels SP1 to SP3. The second openings OP2 may expose portions of the corresponding second anode electrodes AE12, AE22, and AE32 and a portion of the corresponding second cathode electrode CE2.

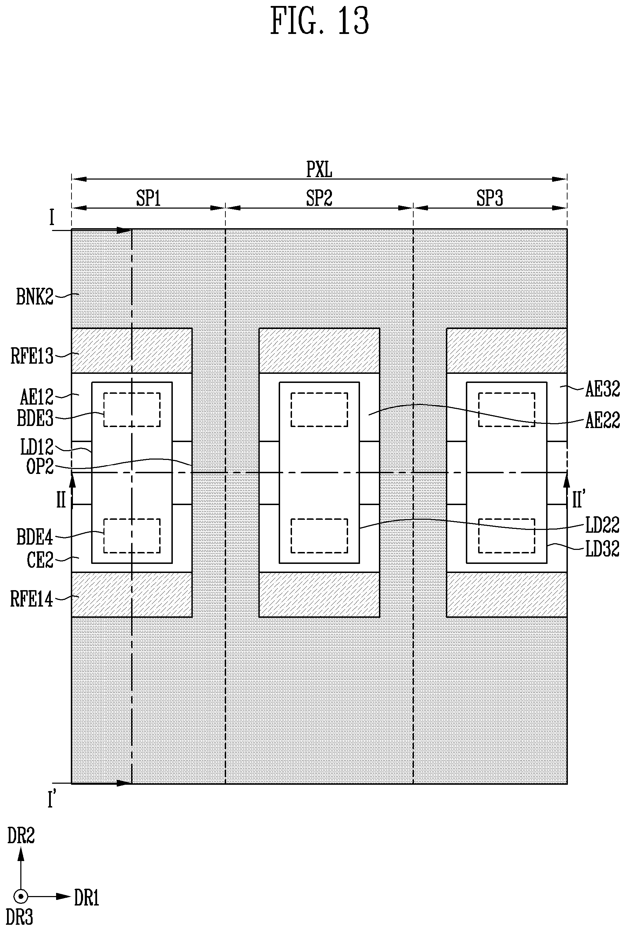

Referring to FIG. 13, third reflective electrodes RFE13 and fourth reflective electrodes RFE14 may be formed on the second bank BNK2.

Thereafter, the second light emitting elements LD12, LD22, and LD32 may be positioned in the second openings OP2 of the second bank BNK2. For example, the third bonding electrode BDE3 of the second light emitting element LD12 of the first sub-pixel SP1 may be positioned on the second anode electrode AE12, and the fourth bonding electrode BDE4 of the second light emitting element LD12 may be positioned on the second cathode electrode CE2. The second light emitting element LD22 of the second sub-pixel SP2 and the second light emitting element LD32 of the third sub-pixel SP3 may also be positioned in the same manner.

Accordingly, the first light emitting elements LD11, LD21, and LD31 and the corresponding second light emitting elements LD12, LD22, and LD32 may be connected in series to each other. The second light emitting elements LD12, LD22, and LD32 may be inorganic light emitting diodes including an inorganic light emitting material. However, the embodiments are not limited thereto and, for example, organic light emitting diodes may be used.

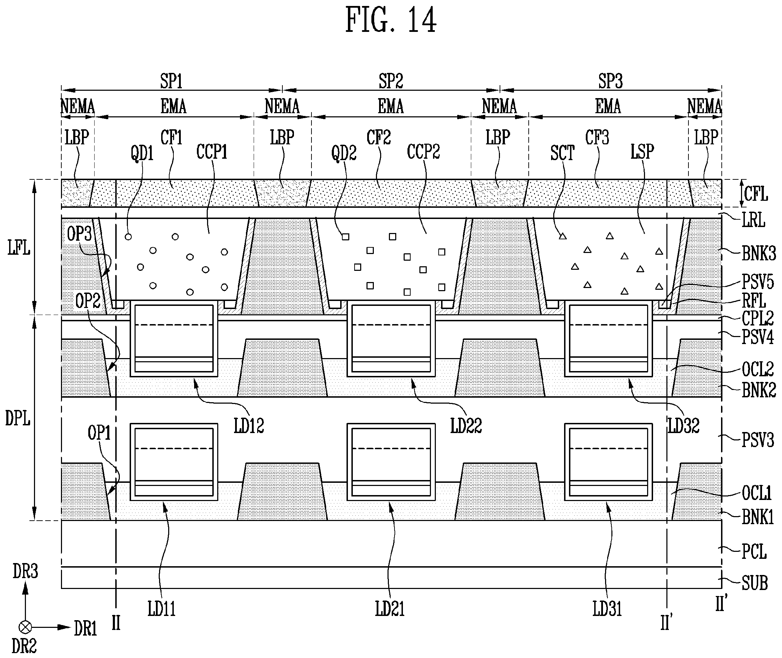

FIG. 14 is a cross-sectional view taken along line II-II' of FIGS. 7 to 13.

Referring to FIG. 14, the pixel circuit layer PCL, the display element layer DPL, and the light functional layer LFL may be sequentially provided on the substrate SUB. In the following descriptions of FIG. 14, contents overlapping those of FIG. 6 will be omitted for descriptive convenience.

The third bank BNK3 may include third openings OP3. An emission area EMA and a non-emission area NEMA for the first to third sub-pixels SP1 to SP3 may be understood as being defined by the third bank BNK3. An area overlapping the third bank BNK3 may correspond to the non-emission area NEMA. Areas overlapping the third openings OP3 of the third bank BNK3 may correspond to the emission areas EMA of the first to third sub-pixels SP1 to SP3.

The first and second light conversion patterns CCP1 and CCP2 and the light scattering pattern LSP may be disposed on the fifth passivation layer PSV5 in the third openings OP3. In embodiments, the first light emitting elements LD11, LD21, and LD31, and the second light emitting elements LD12, LD22, and LD32 may emit blue light. For example, the first light conversion pattern CCP1 may include first color conversion particles QD1 that convert blue light into red light. The second light conversion pattern CCP2 may include second color conversion particles QD2 that convert blue light into green light. The light scattering pattern LSP may include scattering particles SCT for scattering blue light to enhance the light output efficiency. Accordingly, the first to third sub-pixels SP1 to SP3 may be provided (or formed) as a red sub-pixel, a green sub-pixel, and a blue sub-pixel, respectively. In embodiments, at least one of the first and second light conversion patterns CCP1 and CCP2 and the light scattering pattern LSP may further include color conversion particles provided to convert blue light into white light.

In embodiments, the light emitting elements LD11 and LD12 of the first sub-pixel SP1 may emit red light. For example, the light emitting elements LD21 and LD22 of the second sub-pixel SP2 may emit green light. The light emitting elements LD31 and LD32 of the third sub-pixel SP3 may emit blue light. For example, each of the first and second light conversion patterns CCP1 and CCP2 and the light scattering pattern LSP may include scattering particles SCT. For example, particles included in the first and second light conversion patterns CCP1 and CCP2 and the light scattering pattern LSP may be changed in various ways according to the type of light emitting elements.

In another example, the first and second light conversion patterns CCP1 and CCP2 and the light scattering pattern LSP may be omitted.

The low refractive layer LRL may be disposed on the third bank BNK3, the reflective layer RFL, the first light conversion pattern CCP1, the second light conversion pattern CCP2, and the light scattering pattern LSP. The low refractive layer LRL may have a refractive index lower than the first and second light conversion patterns CCP1 and CCP2 and the light scattering pattern LSP. In embodiments, the low refractive layer LRL may be omitted in an area corresponding to the third sub-pixel SP3.

The color filter layer CFL may be disposed on the low refractive layer LRL. The color filter layer CFL may include first to third color filters CF1 to CF3 and light blocking patterns LBP.

Each of the first to third color filters CF1 to CF3 may selectively pass light in a selected wavelength range therethrough. In the case where the first sub-pixel SP1 is a red sub-pixel, the first color filter CF1 may include a red color filter. In the case where the second sub-pixel SP2 is a green sub-pixel, the second color filter CF2 may include a green color filter. In the case where the third sub-pixel SP3 is a blue sub-pixel, the third color filter CF3 may include a blue color filter. Each of the first to third color filters CF1 to CF3 may have a refractive index higher than the low refractive layer LRL. However, the embodiments are not limited thereto, and each of the first to third color filters CF1 to CF3 may have a refractive index equal to or lower than the low refractive layer LRL.

The light blocking patterns LBP may be disposed between the first to third color filters CF1 to CF3. An emission area (or light output area) EMA and a non-emission area NEMA for the first to third sub-pixels SP1 to SP3 may be defined by the light blocking patterns LBP. An area overlapping the light blocking patterns LBP may correspond to the non-emission area NEMA. An area that does not overlap the light blocking patterns LBP may correspond to the emission area EMA.

In embodiments, the light blocking patterns LBP may include at least one of various kinds of light blocking materials. In embodiments, each of the light blocking patterns LBP may be formed in a multilayer structure in which at least two color filters of the first to third color filters CF1 to CF3 overlap each other. For example, each of the light blocking patterns LBP may be formed by overlapping the first to third color filters CF1 to CF3. As another example, a light blocking pattern between the first and second color filters CF1 and CF2 among the light blocking patterns LBP may be formed in a multilayer structure in which the first and second color filters CF1 and CF2 overlap each other, and a light blocking pattern between the second and third color filters CF2 and CF3 among the light blocking patterns LBP may be formed in a multilayer structure in which the second and third color filters CF2 and CF3 overlap each other. A light blocking pattern between the first color filter CF1 and a third color filter CF3 of a neighboring pixel may be formed in a multilayer structure in which the first and third color filters CF1 and CF3 overlap each other. For example, each of the first to third color filters CF1 to CF3 may extend to the non-emission area NEMA, thereby forming the light blocking patterns LBP.

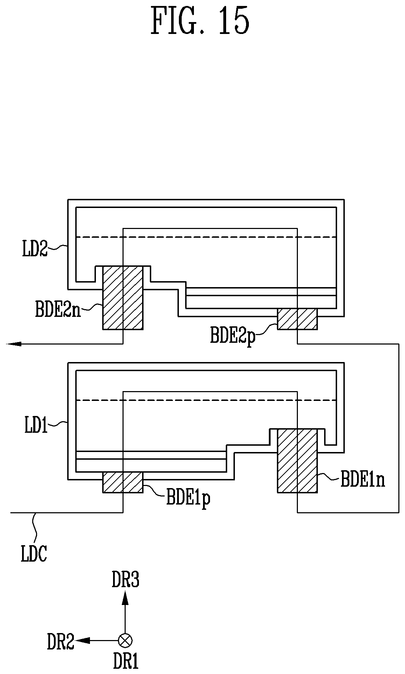

FIGS. 15 to 21 are diagrams illustrating other embodiments of an arrangement structure of light emitting elements.

Referring to FIGS. 15 to 21, the first light emitting element LD1 may include a first bonding electrode BDE1p connected to a p-type semiconductor layer, and a second bonding electrode BDE1n connected to an n-type semiconductor layer. The second light emitting element LD2 may include a third bonding electrode BDE2p connected to a p-type semiconductor layer, and a fourth bonding electrode BDE2n connected to an n-type semiconductor layer. The second light emitting element LD2 may be adjacent to the first light emitting element LD1 in the third direction DR3. For example, the second light emitting element LD2 may be stacked on the first light emitting element LD1.

FIG. 15, unlike the case of FIG. 6, illustrates an embodiment where the first bonding electrode BDE1p is positioned in the second direction DR2 from the second bonding electrode BDE1n. For example, the third bonding electrode BDE2p may be positioned in a direction opposite to the second direction DR2 from the fourth bonding electrode BDE2n. A current path LDC may refer to a direction in which current flows, indicating that the first light emitting element LD1 and the second light emitting element LD2 are connected in series.

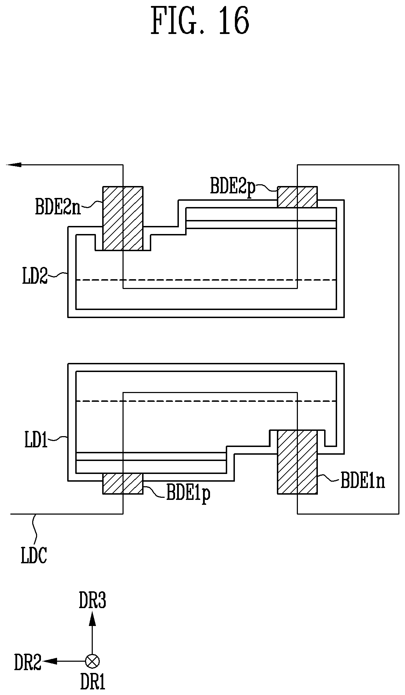

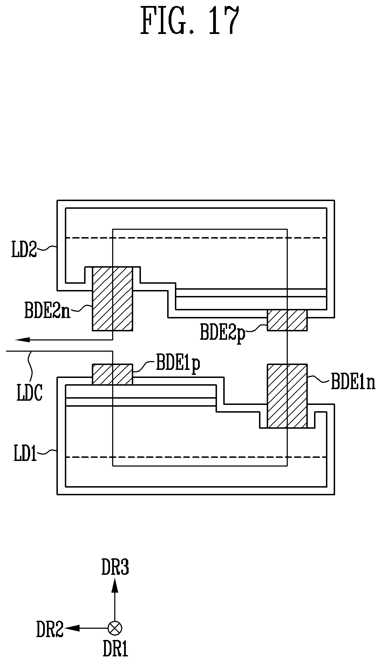

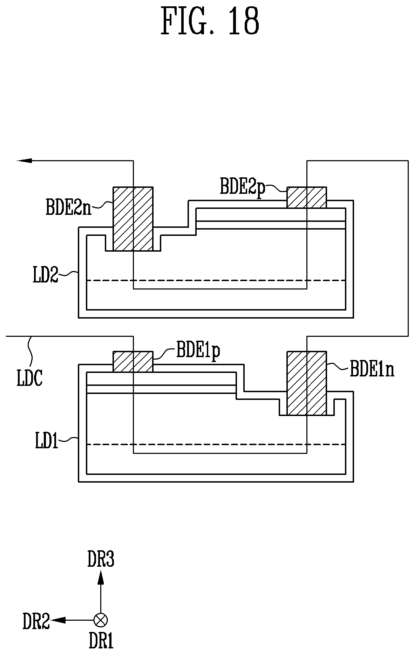

Referring to FIG. 16, the second light emitting element LD2 may be disposed to be inverted with respect to the embodiment of FIG. 15. Referring to FIG. 17, the first light emitting element LD1 may be disposed to be inverted with respect to the embodiment of FIG. 15. Referring to FIG. 18, the first light emitting element LD1 and the second light emitting element LD2 may be disposed to be inverted with respect to the embodiment of FIG. 15.

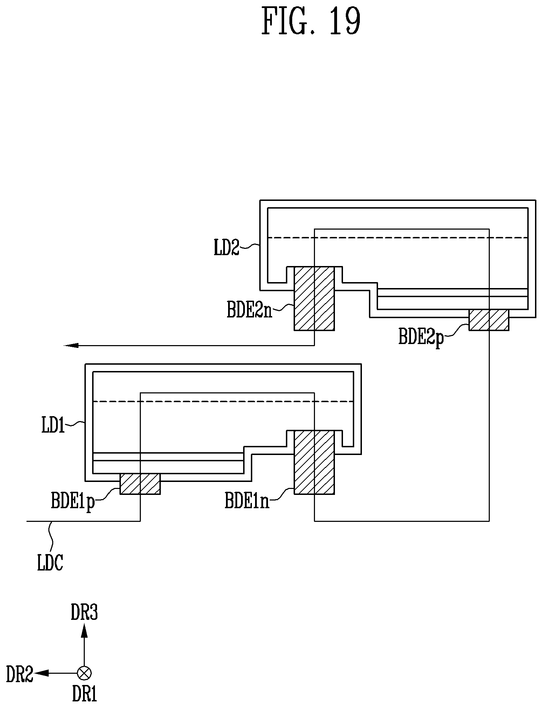

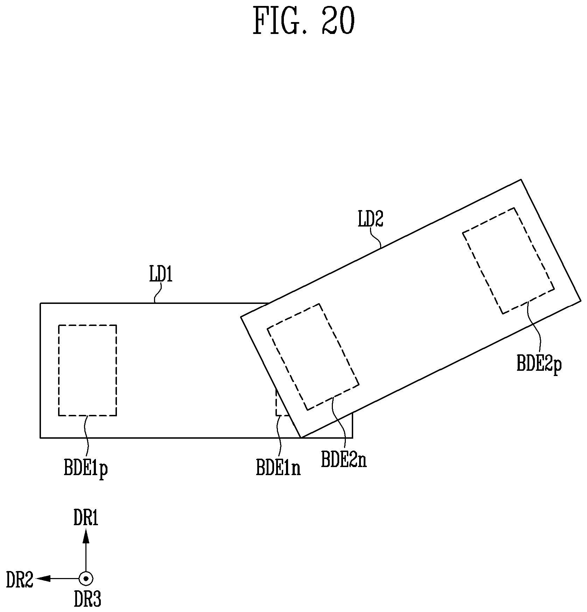

Referring to FIG. 19, a portion of the first light emitting element LD1 and a portion of the second light emitting element LD2 may overlap each other based on the third direction DR3. For example, the second bonding electrode BDE1n of the first light emitting element LD1 and the fourth bonding electrode BDE2n of the second light emitting element LD2 may overlap each other in the third direction DR3. Referring to FIG. 20, in a plane direction (e.g., the first direction DR1 and the second direction DR2), the second light emitting element LD2 may be inclined with respect to the first light emitting element LD1. For example, an imaginary line connecting the first bonding electrode BDE1p and the second bonding electrode BDE1n of the first light emitting element LD1 may not be parallel to an imaginary line connecting the third bonding electrode BDE2p and the fourth bonding electrode BDE2n of the second light emitting element LD2. In accordance with the embodiment, it may be advantageous for providing margin space between the elements.

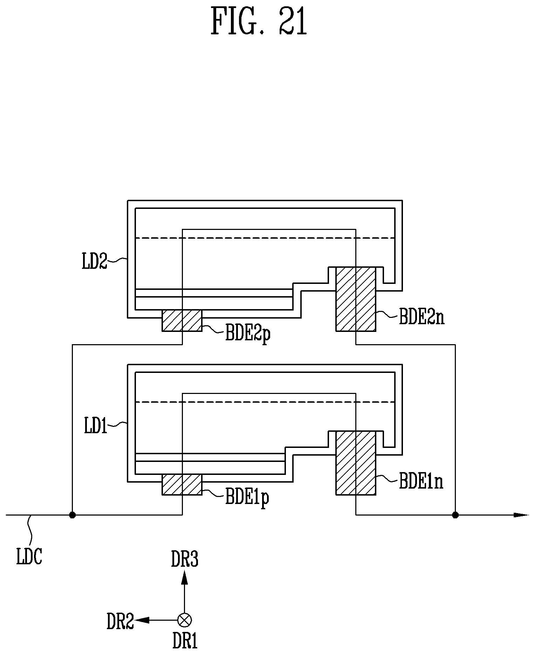

Referring to FIG. 21, the first light emitting element LD1 and the second light emitting element LD2 may be connected in parallel to each other. For example, although a defect occurs in any one of the first light emitting element LD1 and the second light emitting element LD2, the corresponding sub-pixel may display an image with the remaining normal light emitting element.

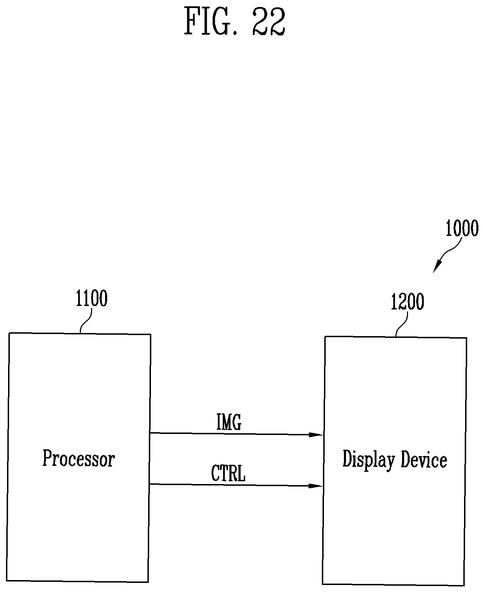

FIG. 22 is a block diagram illustrating an embodiment of a display system.

Referring to FIG. 22, the display system 1000 may include a processor 1100 and a display device 1200.

The processor 1100 may perform various tasks and operations. In embodiments, the processor 1100 may include an application processor, a graphic processor, a microprocessor, a central processing unit (CPU), and so on. The processor 1100 may be connected to the other components of the display system 1000 through a bus system to control the components.

The processor 1100 may transmit input image data IMG and a control signal CTRL to the display device 1200. The display device 1200 may display an image based on the input image data IMG and the control signal CTRL. The display device 1200 may be formed in the same manner as the display device DD described with reference to FIG. 1. For example, the input image data IMG and the control signal CTRL may be provided as the input image data IMG and the control signal CTRL of FIG. 1, respectively.

The display system 1000 may include computing systems that provide an image display function, such as a smart watch, a mobile phone, a smart phone, a portable computer, a tablet personal computer (tablet PC), a watch phone, an automotive display, smart glasses, a portable multimedia player (PMP), a navigation system, and an ultra mobile personal computer (UMPC). Furthermore, the display system 1000 may include at least one of a head mounted display (HMD) device, a virtual reality (VR) device, a mixed reality (MR) device, and an augmented reality (AR) device.

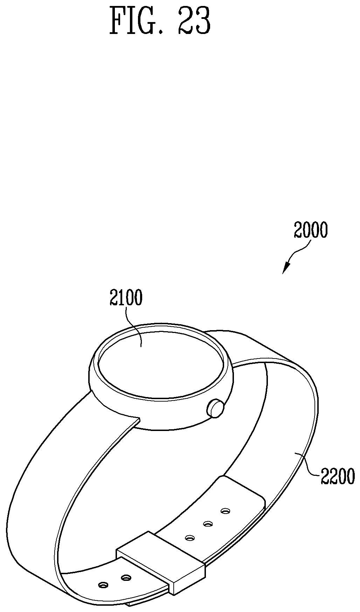

FIGS. 23 to 26 are perspective views illustrating application examples of the display system of FIG. 22.

Referring to FIG. 23, the display system 1000 of FIG. 22 may be applied to a smart watch 2000 including a display component 2100 and a strap 2200.

The smart watch 2000 may be a wearable electronic device. For example, the smart watch 2000 may have a structure in which the strap 2200 may be mounted on the wrist of the user. For example, the display system 1000 and/or the display device 1200 may be applied to the display component 2100, so that image data including time information may be provided to the user.

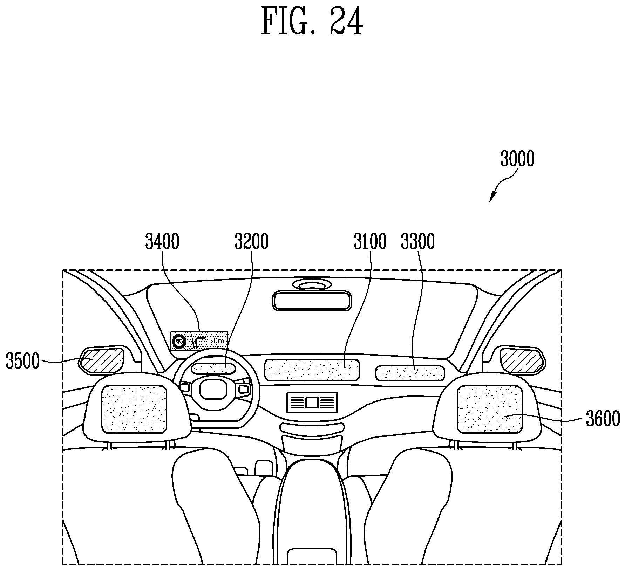

Referring to FIG. 24, the display system 1000 of FIG. 22 may be applied to an automotive display system 3000. For example, the automotive display system 3000 may include a computing system that is provided inside and/or outside a vehicle to provide image data.

For example, the display system 1000 and/or the display device 1200 may be applied to at least any one of an infotainment panel 3100, a cluster 3200, a co-driver display 3300, a head-up display 3400, a side mirror display 3500, and a rear seat display 3600, which are provided in the vehicle.

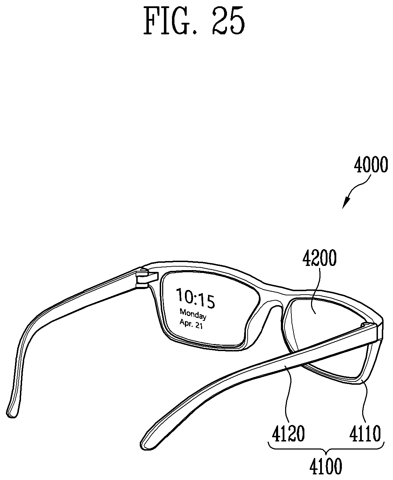

Referring to FIG. 25, the display system 1000 of FIG. 22 may be applied to smart glasses 4000. The smart glasses 4000 may be a wearable electronic device capable of being worn on the head of the user. For example, the smart glasses 4000 may be a wearable device for augmented reality.

The smart glasses 4000 may include a frame 4100 and a lens component 4200. The frame 4100 may include a housing 4110 which supports the lens component 4200, and a leg component 4120 that enables the user to wear the smart glasses. The leg component 4120 may be connected to the housing 4110 by a hinge, and thus may be folded or unfolded with respect to the housing 4110.

The frame 4100 may be equipped with a battery, a touch pad, a microphone, a camera, and the like. Furthermore, the frame 4100 may be equipped with a projector that outputs light, and a processor that controls a light signal and the like.

The lens component 4200 may include an optical component that transmits or reflects light. For example, the lens component 4200 may include glass, transparent synthetic resin, and the like.

To enable the eyes of the user to perceive visual information, the lens component 4200 may reflect images by an optical signal transmitted from the projector of the frame 4100 by a rear surface of the lens component 4200 (e.g., a surface facing the eyes of the user). For example, the user may perceive visual information such as time and date displayed on the lens component 4200. For example, the protector and/or the lens component 4200 may be a kind of display device. The display device 1200 may be applied to the protector and/or the lens component 4200.

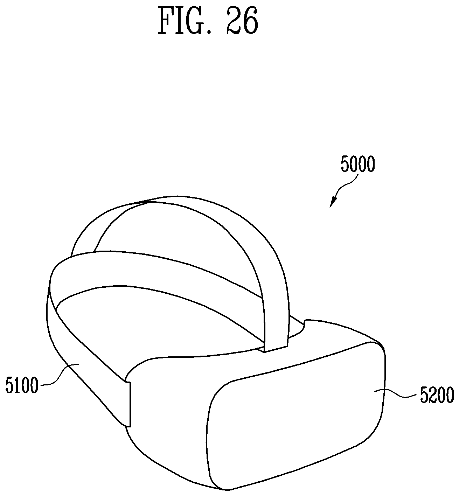

Referring to FIG. 26, the display system 1000 of FIG. 22 may be applied to a head mounted display device 5000.

The head mounted display device 5000 may be a wearable electronic device designed to be worn on the head of the user. For example, the head mounted display device 5000 may be a wearable device for virtual reality or mixed reality.

The head mounted display device 5000 may include a head mounted band 5100 and a display device reception casing 5200. The head mounted band 5100 may be connected to the display device reception casing 5200. The head mounted band 5100 may include a horizontal band and/or a vertical band to fasten the head mounted display device 5000 to the head of the user. The horizontal band may enclose the sides of the head of the user, and the vertical band may enclose the top of the head of the user. However, the embodiments are not limited thereto. For example, the head mounted band 5100 may be implemented in the form of eyeglass frames, a helmet, and so on.

The display device reception casing 5200 may receive the display system 1000 and/or the display device 1200.

The drawings referred to heretofore and the detailed description of the disclosed invention are merely illustrative of the present invention, and are used only for the purpose of describing the present invention, and are not used to limit the meaning or to restrict the scope of the present invention as set forth in the claims. Therefore, those skilled in the art will understand that various modifications and other equivalent embodiments are possible therefrom. Accordingly, the true technical scope of protection of the present invention should be determined by the technical idea of the appended claims.

## Claims

1. A display device comprising:
a substrate;
a pixel circuit layer disposed on the substrate; and
a display element layer disposed on the pixel circuit layer,
wherein the display element layer comprises:
a first bank including a first opening;
a first light emitting element disposed in the first opening, and including a first bonding electrode and a second bonding electrode, the first bonding electrode being electrically connected to an electrode of a first transistor disposed in the pixel circuit layer;
a second bank disposed on the first bank, and including a second opening at least partially overlapping the first opening in a vertical direction; and
a second light emitting element disposed in the second opening, and including a third bonding electrode and a fourth bonding electrode, the third bonding electrode being electrically connected to the second bonding electrode.

2. The display device of claim 1, wherein the display element layer further comprises:
a first anode electrode disposed under the first bank, and electrically connected to the electrode of the first transistor; and
a first reflective electrode disposed on the first anode electrode and the first bank, and connecting the first bonding electrode and the first anode electrode.

3. The display device of claim 2, wherein the display element layer further comprises:
a first cathode electrode disposed under the first bank; and
a second reflective electrode disposed on the first cathode electrode and the first bank, and connecting the second bonding electrode and the first cathode electrode.

4. The display device of claim 3, wherein the display element layer further comprises a second anode electrode connecting the second reflective electrode and the third bonding electrode.

5. The display device of claim 4, wherein the display element layer further comprises:
a common electrode connected in common to a plurality of sub-pixel circuits; and
a second cathode electrode electrically connecting the fourth bonding electrode and the common electrode.

6. The display device of claim 5, wherein the display element layer further comprises a common connection electrode disposed on the first bank and the common electrode, and connected to the second cathode electrode.

7. The display device of claim 6, wherein the common connection electrode is spaced apart from the first reflective electrode.

8. The display device of claim 6, wherein the common connection electrode is connected in common to the plurality of sub-pixel circuits.

9. The display device of claim 5, wherein the second cathode electrode is connected in common to the plurality of sub-pixel circuits.

10. The display device of claim 1, wherein
the first light emitting element includes an n-type semiconductor layer and a p-type semiconductor layer,
the first bonding electrode is connected to the p-type semiconductor layer of the first light emitting element, and
the second bonding electrode is connected to the n-type semiconductor layer of the first light emitting element.

11. The display device of claim 10, wherein
the second light emitting element includes an n-type semiconductor layer and a p-type semiconductor layer,
the third bonding electrode is connected to the p-type semiconductor layer of the second light emitting element, and
the fourth bonding electrode is connected to the n-type semiconductor layer of the second light emitting element.

12. A method of fabricating a display device, the method comprising:
preparing a substrate;
forming a pixel circuit layer on the substrate; and
forming a display element layer on the pixel circuit layer, wherein
the forming of the display element layer comprises:
forming a first bank including a first opening;
disposing a first light emitting element in the first opening;
forming, on the first bank, a second bank including a second opening at least partially overlapping the first opening in a vertical direction; and
disposing a second light emitting element in the second opening, and
the first light emitting element and the second light emitting element are connected in series to each other.

13. The method of claim 12, wherein
the forming of the display element layer comprises:
forming a first contact hole in a first insulating layer of the pixel circuit layer; and
forming a first anode electrode, a first cathode electrode, and a common electrode on the first insulating layer, and
the first anode electrode overlaps the first contact hole.

14. The method of claim 13, wherein the forming of the display element layer further comprises:
forming a first reflective electrode disposed on the first bank and the first anode electrode, a second reflective electrode disposed on the first bank and the first cathode electrode, and a common connection electrode disposed on the first bank and the common electrode.

15. The method of claim 14, wherein the disposing of the first light emitting element comprises:
disposing a first bonding electrode of the first light emitting element on the first reflective electrode, and
disposing a second bonding electrode of the first light emitting element on the second reflective electrode.

16. The method of claim 15, wherein the forming of the display element layer comprises:
forming a second insulating layer on the first light emitting element; and
forming, in the second insulating layer, a second contact hole through which the second reflective electrode is exposed, and a third contact hole through which the common connection electrode is exposed.

17. The method of claim 16, wherein
the forming of the display element layer further comprises forming a second anode electrode and a second cathode electrode on the second insulating layer,
the second anode electrode overlaps the second contact hole, and
the second cathode electrode overlaps the third contact hole.

18. The method of claim 17, wherein the disposing of the second light emitting element comprises:
disposing a third bonding electrode of the second light emitting element on the second anode electrode, and
disposing a fourth bonding electrode of the second light emitting element on the second cathode electrode.

19. The method of claim 17, wherein the second cathode electrode is connected in common to a plurality of sub-pixel circuits.

20. The method of claim 19, wherein the common electrode is connected in common to the plurality of sub-pixel circuits.
